# EUROPEAN PATENT APPLICATION

(11) **EP 4 057 348 A2**
(43) Date of publication of application: **14.09.2022**
(21) Application number: 22160758.3
(22) Date of filing: 08.03.2022
(51) Int. Cl.: H01L 27/11, H01L 27/02, G06F 30/39

(54) **SRAM CELL STRUCTURES**

(30) Priority: 10.03.2021 US 202163158896 P; 18.03.2021 US 202163162569 P; 06.08.2021 US 202117395922
(71) Applicant: Invention And Collaboration Laboratory Pte. Ltd., Singapore 068914 (SG)
(72) Inventor: LU, Chao-Chun, Hsinchu 30078 (TW); HUANG, Li-Ping, Hsinchu 30078 (TW); CHUEH, Juang-Ying, Hsinchu 30078 (TW)
(74) Representative: Krauns, Christian

(57) **Abstract**

A SRAM cell includes a plurality of transistors, a set of contacts coupled to the plurality of transistors, a word-line electrically coupled to the plurality of transistors, a bitline and a bit line bar electrically coupled to the plurality of transistors, a VDD contacting line electrically coupled to the plurality of transistors, and a VSS contacting line electrically coupled to the plurality of transistors, wherein as the minimum feature size of the SRAM cell gradually decreases from 28nm, an area size of the SRAM cell in terms of square of a minimum feature size (λ) is the same or substantially the same.

## Description

### BACKGROUND

### Technical Field

The present invention relates to memory structure, and particularly to a SRAM structure which can have precisely controlled dimensions to effectively shrink a size of the SRAM structure.

### Description of the Related Art

Improvement in integrated circuit performance and cost has been achieved largely by process scaling technology according to Moore's Law, but the process variations in transistor performance with miniaturization down to the 28 nm (or lower) manufacture process is a challenge. Especially, SRAM device scaling for increased storage density, reduction in operating voltage (VDD) for lower stand-by power consumption, and enhanced yield necessary to realize larger-capacity SRAM become increasingly difficult to achieve.

SRAM is one of the commonly used memory. SRAM usually comprises SRAM array and peripheral circuits which includes row address decoder, column address decoder, and input/output circuits, etc. The SRAM array includes multiple SRAM cells, each SRAM cell incorporates a static latch with two cross-coupled inverters, so that it does not require DRAM periodic refreshing to retain the stored information, provided that there is adequate power supply voltages for the cell, i.e. a high level voltage VDD and a low level voltage VSS. The same high level voltage VDD and the low level voltage VSS are connected to the SRAM peripheral circuits (decoders, I/O circuits) as well. Furthermore, the high level voltage VDD usually corresponds to logic "1" stored in SRAM and the low level voltage VSS corresponds to logic "0" stored in SRAM.

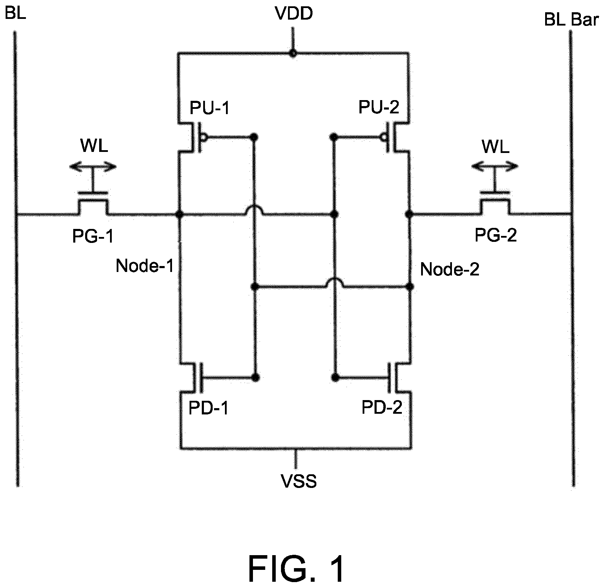

Fig. 1 shows the SRAM cell architecture, that is the six-transistor (6-T) SRAM cell. It consists of two cross-coupled inverters (PMOS pull-up transistors PU-1 and PU-2 and NMOS pull-down transistors PD-1 and PD-2) and two access transistors (NMOS pass-gate transistors PG-1and PG-2). The high level voltage VDD is coupled to the PMOS pull-up transistors PU-1 and PU-2, and the low level voltage VSS are coupled to the NMOS pull-down transistors PD-1 and PD-2. When the word-line (WL) is enabled (i.e., a row is selected in an array), the access transistors are turned on, and connect the storage nodes (Node-1/Node-2) to the vertically-running bit-lines (BL and BL Bar).

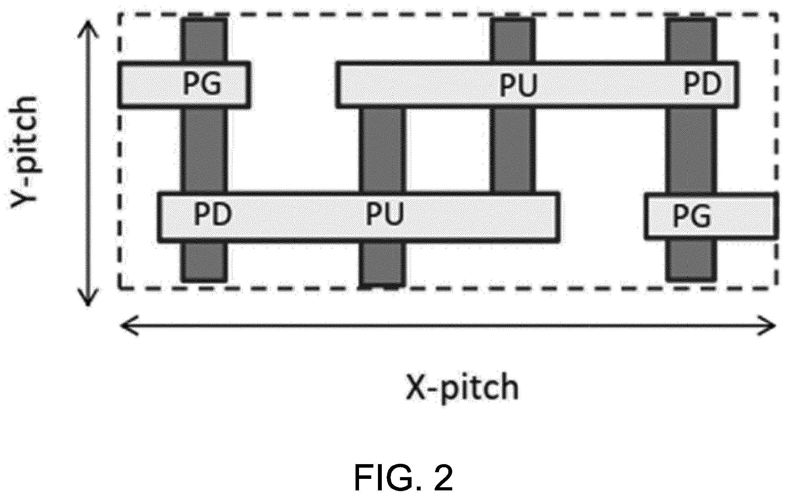

Fig. 2 shows the "stick diagram" representing the layout and connection among the 6 transistors of the SRAM. The stick diagram usually just includes active regions (vertical red line) and gate lines (horizontal blue lines). Of course, there are still lots of contacts, on one hand directly coupled to the 6 transistors, and on the other hand, coupled to the word-line (WL), bit-lines (BL and BL Bar), high level voltage VDD, and low level voltage VSS, etc.

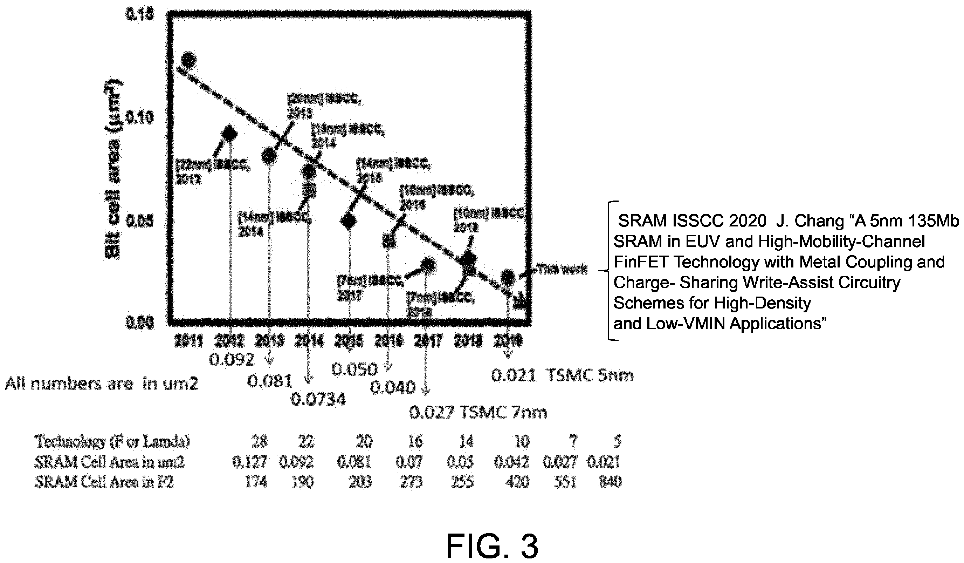

However, even miniaturization of the manufacture process down to the 28 nm or lower (so called, "minimum feature size", "λ", or "F"), due to the interference among the size of the contacts, among layouts of the metal wires connecting the word-line (WL), bit-lines (BL and BL Bar), high level voltage VDD, and low level voltage VSS, etc., the total area of the SRAM cell represented by λ² or F² dramatically increases when the minimum feature size decreases, as shown in Fig. 3 (cited from J. Chang et al., "15.1 A 5nm 135Mb SRAM in EUV and High-Mobility-Channel FinFET Technology with Metal Coupling and Charge-Sharing Write-Assist Circuitry Schemes for High-Density and Low-VMIN Applications," 2020 IEEE International Solid- State Circuits Conference - (ISSCC), 2020, pp. 238-240,).

Some of the reasons for the dramatically increase of the total area of the SRAM cell represented by λ² or F² when the minimum feature size decreases could be described as follows. The traditional 6T SRAM has six transistors which are connected by using multiple interconnections, which has its first interconnection layer M1 to connect the gate-level ("Gate") and the diffusion-level of the Source-region and the Drain-region (called generally as "Diffusion") of the transistors. There is a need to increase a second interconnection layer M2 and/or a third interconnection layer M3 for facilitating signal transmission (such as the word-line (WL) and/or bit-lines (BL and BL Bar)) without enlarging the die size by only using M1, then a structure Via-1, which is composed of some types of the conductive materials, is formed for connecting M2 to M1. Thus, there is a vertical structure which is formed from the Diffusion through a Contact (Con) connection to M1, i.e. "Diffusion-Con-M1". Similarly, another structure to connect the Gate through a Contact structure to M1 can be formed as "Gate-Con-M1". Additionally, if a connection structure is needed to be formed from an M1 interconnection through a Via1 to connect to an M2 interconnection, then it is named as "M1-Via1-M2". A more complex interconnection structure from the Gate-level to the M2 interconnection can be described as "Gate-Con-M1-Via1-M2". Furthermore, a stacked interconnection system may have an "M1-Via1-M2-Via2-M3" or "M1-Via1-M2-Via2-M3-Via3-M4" structure, etc. Since the Gate and the Diffusion in two access transistors (NMOS pass-gate transistors PG-1 and PG-2, as shown in Fig. 1) shall be connected to the word-line (WL) and/or bit-lines (BL and BL Bar) which will be arranged in the second interconnection layer M2 or the third interconnection layer M3, in traditional SRAM such metal connections must go through interconnection layer M1 first. That is, the state-of-the-art interconnection system in SRAM may not allow the Gate or Diffusion directly connect to M2 without bypassing the M1 structure. As results, the necessary space between one M1 interconnection and the other M1 interconnection will increase the die size and in some cases the wiring connections may block some efficient channeling intention of using M2 directly to surpass M1 regions. In addition, there is some difficulty to form a self-alignment structure between Via1 to Contact and at the same time both Via1 and Contact are connected to their own interconnection systems, respectively.

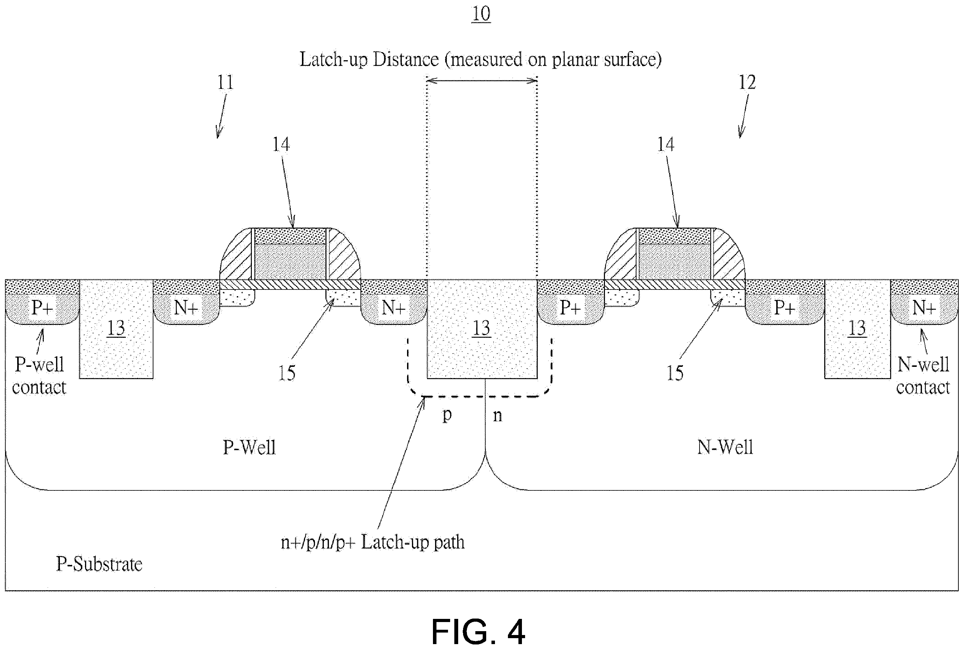

Additionally, in traditional 6T SRAM cell, at least there are one NMOS transistor and one PMOS transistor located respectively inside some adjacent regions of p-substrate and n-well which have been formed next to each other within a close neighborhood, a parasitic junction structure called n+/p/n/p+ parasitic bipolar device is formed with its contour starting from the n+ region of the NMOS transistor to the p-well to the neighboring n-well and further up to the p+ region of the PMOS transistor, as shown in Fig. 4. There are significant noises occurred on either n+/p junctions or p+/n junctions, an extraordinarily large current may flow through this n+/p/n/p+ junction abnormally which can possibly shut down some operations of CMOS circuits and to cause malfunction of the entire chip. Such an abnormal phenomenon called Latch-up is detrimental for CMOS operations and must be avoided. One way to increase the immunity to Latch-up which is certainly a weakness for CMOS is to increase the distance from n+ region to the p+ region. Thus, the increase of the distance from n+ region to the p+ region to avoid Latch-up issue will also enlarge the size of the SRAM cell.

Therefore, how to redesign the SRAM cell such that the total area of the SRAM cell represented by λ² could maintain within an acceptable range when the minimum feature size decreases is a challenge.

### SUMMARY

An embodiment of the present invention provides a SRAM structure. The SRAM cell includes a plurality of transistors, a set of contacts coupled to the plurality of transistors, a word-line electrically coupled to the plurality of transistors, a bit-line and a bit line bar electrically coupled to the plurality of transistors, a VDD contacting line electrically coupled to the plurality of transistors, and a VSS contacting line electrically coupled to the plurality of transistors. Wherein as the minimum feature size of the SRAM cell gradually decreases from 28nm (such as to 16nm, to 10nm, to 7 nm, to 5nm, or to 3nm, etc.), an area size of the SRAM cell in terms of square of a minimum feature size (λ) is the same or substantially the same.

According to another aspect of the invention, as the minimum feature size of the SRAM cell gradually decreases from 28nm, an area size of the SRAM cell in terms of square of a minimum feature size (λ) is the same or substantially the same.

According to another aspect of the invention, when λ is decreased from 28nm to 5nm, the area size of the SRAM cell is between 84λ²~139 λ².

According to another aspect of the invention, a length of one transistor is between 3~4λ.

According to another aspect of the invention, a gate region of one transistor in the plurality of transistors is connected to a source region or a drain region of the transistor directly through a first metal interconnection without another metal layer lower than the first metal interconnection.

According to another aspect of the invention, the VDD contacting line or the VSS contacting line is distributed under an original silicon surface of a substrate from which the plurality of transistors are formed.

According to another aspect of the invention, a bottom surface of a n+ region of a NMOS transistor of the plurality of transistors is fully isolated by a first insulator, and a bottom surface of a p+ region of a PMOS transistor of the plurality of transistors is fully isolated by a second insulator.

According to another aspect of the invention, an edge distance between the n+ region of the NMOS transistor and the p+ region of a PMOS transistor is between 2λ~4λ.

According to another aspect of the invention, he set of contacts comprise a set of first contacts and a set of second contacts, the set of first contacts are connected to the first metal layer, and the set of second contacts are connected to the second metal layer but disconnected from the first metal layer.

It maybe one object of the invention to provide a SRAM structure with a smaller area. The SRAM cell includes a plurality of transistors, a set of contacts coupled to the plurality of transistors, a word-line electrically coupled to the plurality of transistors, a bit-line and a bit line bar electrically coupled to the plurality of transistors, a VDD contacting line electrically coupled to the plurality of transistors, and a VSS contacting line electrically coupled to the plurality of transistors, wherein the area of the SRAM cell is within the range of 84λ²~672λ² when the minimum feature size is 5nm, the area of the SRAM cell is within the range of 84λ²~440λ² when the minimum feature size is 7nm, the area of the SRAM cell is within the range of 84λ²~300λ² when the minimum feature size is between 10nm to more than 7nm, the area of the SRAM cell is within the range of 84λ²~204λ² when the minimum feature size is between 16nm to more than 10nm, the area of the SRAM cell is within the range of 84λ²~152λ² when the minimum feature size is between 22nm to more than 16nm, the area of the SRAM cell is within the range of 84λ²~139λ² when the minimum feature size is between 28nm to more than 22nm.

Another embodiment of the present invention provides a SRAM structure with direct connection from gate/diffusion to metal 2 layer. The SRAM includes a plurality of transistors, a plurality of contacts coupled to the plurality of transistors, a first metal layer disposed above and electrically coupled to the plurality of transistors, a second metal layer disposed above the first metal layer and electrically coupled to the plurality of transistors, a third metal layer disposed above the second metal layer and electrically coupled to the plurality of transistors, wherein the plurality of contacts comprise a set of first contacts and a set of second contacts, the set of first contacts are connected to the first metal layer, and the set of second contacts are connected to the second metal layer but disconnected from the first metal layer.

According to another aspect of the invention, a vertical length of the first contact is shorter than that of the second contact.

According to another aspect of the invention, a gate region of one transistor in the plurality of transistors is connected to a source region or a drain region of the transistor directly through a first metal interconnection without another metal layer lower than the first metal interconnection.

According to another aspect of the invention, a bottom surface of a n+ region of a NMOS transistor of the plurality of transistors is fully isolated by a first insulator, and a bottom surface of a p+ region of a PMOS transistor of the plurality of transistors is fully isolated by a second insulator, and wherein an edge distance between the n+ region of the NMOS transistor and the p+ region of a PMOS transistor is between 2λ-4λ.

It maybe another object of the invention to provides a SRAM structure with miniatured transistors. The SRAM includes a plurality of transistors. Wherein one transistor comprises a gate structure with a length, a channel region, a first conductive region electrically coupled to the channel region, and a first contact hole positioned above the first conductive region, wherein a periphery of the first contact hole is independent from a photolithography process.

According to another aspect of the invention, the first contact hole includes a periphery surrounded by a circumference of the first conductive region.

According to another aspect of the invention, a gate region of one transistor in the plurality of transistors is connected to a source region or a drain region of the transistor directly through a first metal interconnection without another metal layer lower than the first metal interconnection.

The advantages and spirits of the invention may be understood by the following recitations together with the appended drawings. These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

The patent or application file contains at least one drawing executed in color. Copies of this patent or patent application publication with color drawing will be provided by the USPTO upon request and payment of the necessary fee.
FIG. 1 is a schematic diagram for a regular 6T SRAM.
FIG. 2 is a stick diagram corresponding to the 6T SRAM in Fig. 1, in which active regions are corresponding to the vertical lines and gate lines are corresponding to the horizontal lines.
FIG. 3 is a diagram illustrating the total area of the SRAM cell in terms of λ² (or F²) for different process dimension λ (or F) according to the currently available manufacture processes.
FIG. 4 is a diagram illustrating a diagram illustrating a cross section of a traditional NMOS and PMOS structure.
FIG. 5 is a diagram illustrating a top view of a miniaturized metal-oxide-semiconductor field-effect transistor (mMOSFET) used in the SRAM according to the present invention.
FIG. 6 is a diagram illustrating a cross-section of pad-oxide layer, the pad-nitride layer on the substrate, and the STI-oxide1 formed in the substrate.
FIG. 7 is a diagram illustrating the true gate (TG) and the dummy shield gate (DSG) formed on above the active region.
FIG. 8 is a diagram illustrating the spin-on dielectrics (SOD) being deposited, and a well-designed gate mask layer being deposited and etched.
FIG. 9 is a diagram illustrating the nitride layer above the dummy shield gate(DSG), the DSG, portion of the dielectric insulator corresponding to the DSG, and the p-type substrate 102 corresponding to the DSG are removed.
FIG. 10 is a diagram illustrating the gate mask layer being removed, the SOD being etched, and an oxide-2 layer being deposited to form a STI-oxide2.
FIG. 11 is a diagram illustrating the oxide-3 layer being deposited and etched to form the oxide-3 spacer, the lightly Doped drains (LDDs) being formed in the p-type substrate, the nitride layer being deposited and etched back to form the nitride spacer, and the dielectric insulator being removed.

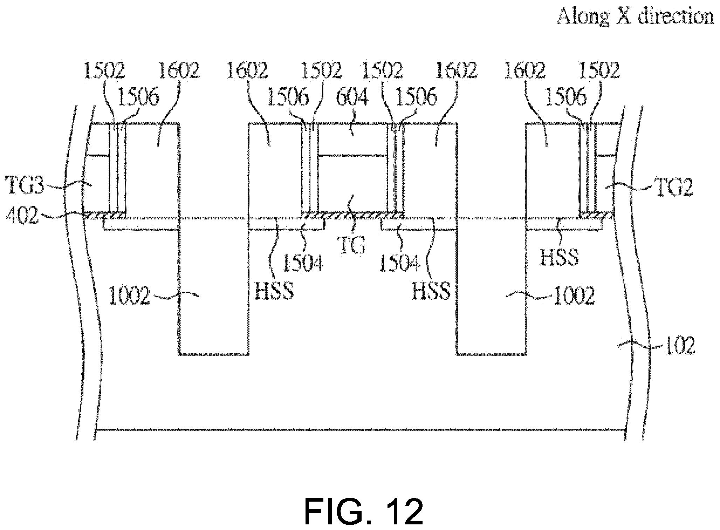

FIG. 12 is a diagram illustrating the intrinsic silicon electrode being grown by the selective epitaxy growth (SEG) technique.
FIG. 13 is a diagram illustrating the CVD-STI-oxide3 layer being deposited and etched back, the intrinsic silicon electrode being removed, and the source (n+ source) and the drain (n+ drain) of the mMOSFET being formed.
FIG. 14 is a diagram illustrating the oxide spacer being deposited and etched to form the contact-hole openings.
FIG. 15 (a) is a diagram illustrating a layer of SOD is deposited to fill the vacancies on the substrate, and use CMP to make the surface flat.
FIG. 15(b) is the top view of the FIG. 15(a).
FIG. 16 is a diagram illustrating the photo resistance layer formed over the structure in FIG. 15(b).
FIG. 17 is a diagram illustrating an anisotropic etching technique to remove the Nitride-cap layer within the exposed gate extension region to reveal the conductive Metal-gate layer.
FIG. 18(a) is a diagram illustrating the photo resistance layer and the SOD layers being removed to form opening regions on top of both the source region and the drain region, and the spacers being formed.
FIG. 18(b) is the top view of the FIG. 18(a).
FIG. 19(a) is a diagram illustrating the layer of Metal-1 interconnection networks being formed.
FIG. 19(b) is the top view of the FIG. 19(a), in which the gate is connected to the source region through the Metal-1 layer.
FIG. 20 (a) is a diagram illustrating the top view of a transistor of the new 6T SRAM up to its constructed phase of making multiple opening-holes on top of both gate extension region and drain region.
Figs. 20(b) and 20(c) are two cross sections of the constructed phase of the transistor along Cutline 1 and Cutline 2 shown in Fig. 20(a).
FIG. 21 (a) is a diagram illustrating the top view of a transistor of the new 6T SRAM up to its constructed phase of using a Selective Epitaxy Growth Technique (SEG) to grow heavily doped conductive silicon plug (CoP).
Figs. 21(b) and 21(c) are two cross sections of the constructed phase of the transistor along Cutline 1 and Cutline 2 shown in Fig. 21(a).
FIG. 22 (a) is a diagram illustrating the top view of a transistor of the new 6T SRAM up to its constructed phase of depositing an oxide layer or low-k dielectric layer to a height which is taller than these conductor pillars (CoP).
Figs. 22(b) and 22(c) are two cross sections of the constructed phase of the transistor along Cutline 1 and Cutline 2 shown in Fig. 22(a).
FIG. 23 (a) is a diagram illustrating the top view of a transistor of the new 6T SRAM up to its constructed phase of depositing a metal M1 layer and a thin oxide layer on top of the metal M1 layer, and using these exposed heads of the conductor pillar (CoP) as seeds to form a heavily doped silicon pillars (CoP2) by SEG method.
Figs. 23(b) and 23(c) are two cross sections of the constructed phase of the transistor along Cutline 1 and Cutline 2 shown in Fig. 23(a).
FIG. 24 (a) is a diagram illustrating the top view of a transistor of the new 6T SRAM up to its constructed phase of depositing a layer of either oxide or low-k dielectric between and over the metal M1 layer, and then depositing a Metal M2 layer to connect the heavily doped silicon pillars (CoP2).
Figs. 24(b) and 24(c) are two cross sections of the constructed phase of the transistor along Cutline 1 and Cutline 2 shown in Fig. 24(a).
FIGS. 25(a) and 25(b) are diagrams illustrating the cross section of the PMOS transistor and the NMOS transistor used in the SRAM cell, respectively.
FIG. 26(a) is a top view diagram illustrating a combination structure of the new PMOS 52 and new NMOS 51 shown in FIGS. 25(a) and 25(b).
FIG. 26(b) is a diagram illustrating a cross section of the combination of the new PMOS 52 and new NMOS 51 along the cutline (Y-axis) in FIG. 26(a).
FIG. 27 is a diagram illustrating a cross section of one combination of the traditional PMOS transistor and NMOS transistor.
FIG. 28(a) is a top view diagram illustrating another combination structure of the new PMOS 52 and new NMOS 51 shown in FIGS. 25(a) and 25(b).
FIG. 28(b) is a diagram illustrating a cross section of the combination of the new PMOS 52 and new NMOS 51 along the cutline (X-axis) in FIG. 28(a).
FIG. 29 is a diagram illustrating a cross section of another combination of the traditional PMOS and NMOS transistor.
FIG. 30 is a top view diagram illustrating another combination structure of the PMOS and NMOS transistors used in the new SRAM cell.
Fig. 31 (a) a diagram illustrating the "stick diagram" as Fig. 2, and Fig. 31(b) is a stick diagram of the new 6T SRAM with dimension according to the present invention.
Fig. 32 is a list illustrating the definition for different mask layers used in Figs. 33~37.
Figs. 33(a)~(g) show one embodiment according to the present invention.
Figs. 34(a)~(h) show another embodiment according to the present invention.
Figs. 35(a)~(h) show another embodiment according to the present invention.
Figs. 36(a)~(h) show another embodiment according to the present invention.
Figs. 37(a)~(h) still show another embodiment according to the present invention.
Figure 38 shows the SRAM cell area (in term λ²) across different technology nodes from three different foundries A, B, and C and the present invention.

### DETAILED DESCRIPTION

In traditional 6T SRAM cell, even miniaturization of the manufacture process is down to the 28 nm or lower (so called, "minimum feature size", "λ", or "F"), the size of transistor could not be diminished proportionally. The present invention discloses a new SRAM structure in which the linear dimensions of the source, the drain and the gate of the transistors in the SRAM are precisely controlled, and the linear dimension can be as small as the minimum feature size, Lamda (λ). Therefore, when two adjacent transistors are connected together through the drain/source, the distance between the edges of the gates of the two adjacent transistors could be as small as 2λ. Additionally, a linear dimension for a contact hole for the source, the drain and the gate could be less than λ, such as 0.6λ~0.8λ, can be achieved within the drain area(so is within the source area and the gate area).

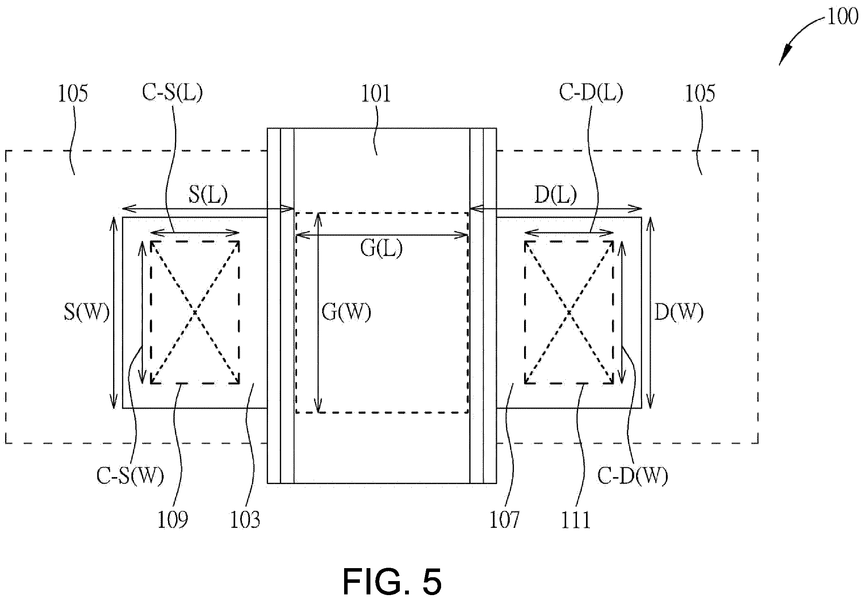

Fig. 5 is an example of a miniaturized metal oxide semiconductor field effect transistor (mMOSFET) 100 used in the SRAM according to the present invention. As shown in FIG. 5, the mMOSFET 100 includes: (1) a gate structure 101 has a length G(L) and a width G(W), (2) on a left-hand side of the gate structure 101, a source 103 has a length S(L) which is a linear dimension from an edge of the gate structure 101 to an edge of an isolation region 105 and a width S(W), (3) on a right-hand side of the gate structure 101, a drain 107 has a length D(L) which is a linear dimension from the edge of the gate structure 101 to the edge of the isolation region 105 and a width D(W), (4) at a center of the source 103, a contact-hole 109 formed by a self-alignment technology has length and width of an opening labeled as C-S(L) and C-S(W), respectively, and (5) similarly at a center of the drain 107, a contact hole 111 formed by the self-alignment technology has length and width of an opening labeled as C-D(L) and C-D(W), respectively. The length G(L), the length D(L), and the length S(L) could be precisely controlled as small as the minimum feature size λ. Furthermore, the length and width of an opening labeled as C-S(L) and C-S(W) or the length and width of an opening labeled as D-S(L) and D-S(W)could be less than λ, such as 0.6λ~0.8λ.

The following briefly describes the manufacture process for the aforesaid mMOSFET 100 used in the SRAM of the present invention. The detailed description for the structure of the mMOSFET 100 and the manufacture process thereof is presented in the US Patent Application No. 17/138,918, filed on Dec. 31, 2020 and entitled: "MINIATURIZED TRANSISTOR STRUCTURE WITH CONTROLLED DIMENSIONS OF SOURCE/DRAIN AND CONTACT-OPENING AND RELATED MANUFACTURE METHOD", and the whole content of the US Patent Application No. 17/138,918 is incorporated by reference herein.

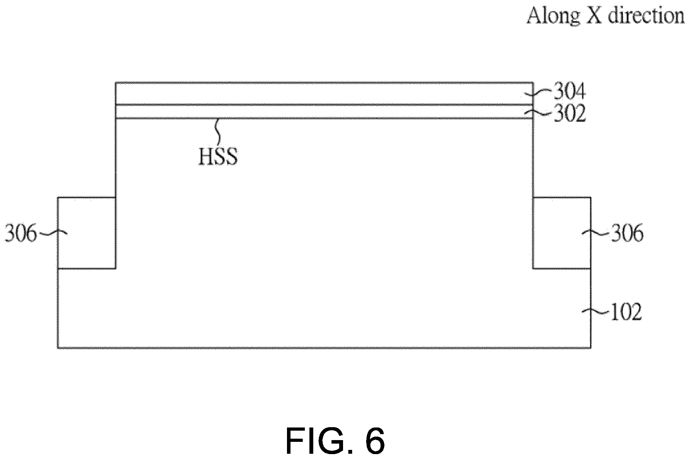

As shown in Fig. 6, a pad-oxide layer 302 is formed and a pad-nitride layer 304 is deposited on the substrate 102. The active region of the mMOSFET is also defined and remove parts of silicon material outside the active region to create the trench structure. An oxide-1 layer is deposited in the trench structure and etched back to form a shallow trench isolation (STI-oxide1) 306 below the original horizontal surface of the silicon substrate ("HSS").

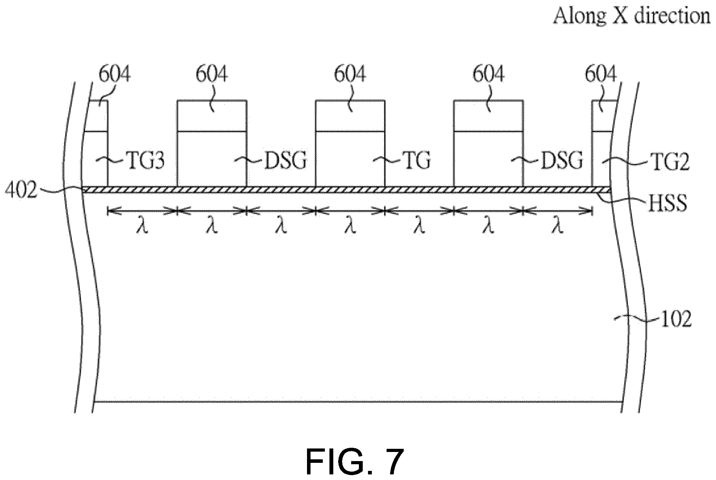

The pad-oxide layer 302 and the pad-nitride layer 304 are removed, and a dielectric insulator 402 is formed over the HSS. Then, a gate layer 602 and a nitride layer 604 are deposited above the HSS, and the gate layer 602 and the nitride layer 604 are etched to form a true gate of the mMOSFET and dummy shield gates with a desired linear distance to the true gate, as shown in Fig. 7. As shown in Fig. 7, the length of the true gate is and the dummy shield gate is λ, the length of the dummy shield gate is also λ, and the distance between the edges of the true gate and the dummy shield gate is λ as well.

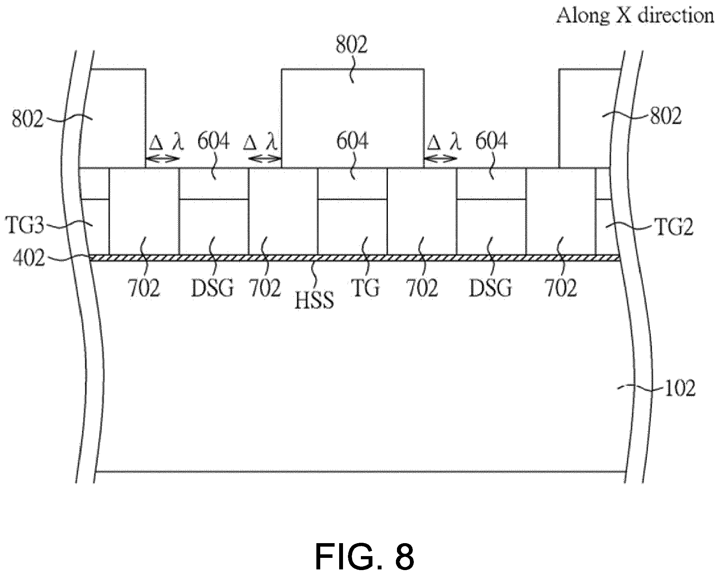

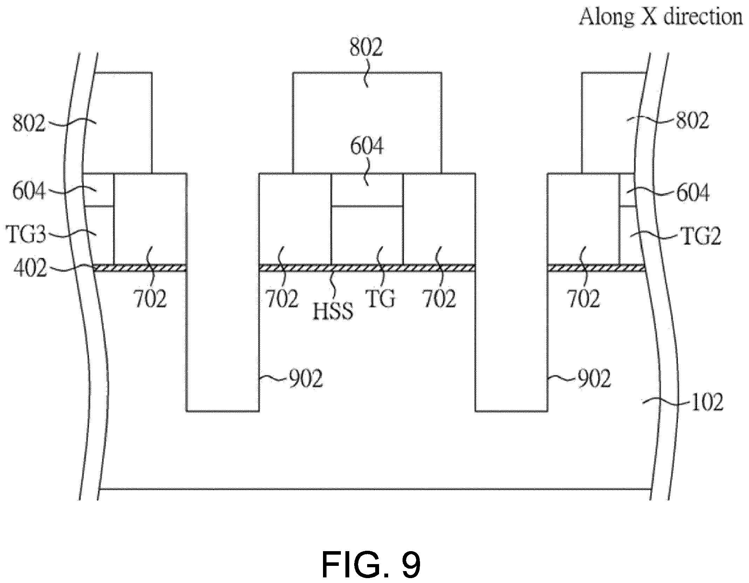

Then, deposit a spin-on dielectrics (SOD) 702, and then etch back the SOD 702. Form a well-designed gate mask layer 802 by the photolithographic masking technique, as shown in Fig. 8. Thereafter, utilize the anisotropic etching technique to remove the nitride layer 604 above the dummy shield gate(DSG), and remove the DSG, portion of the dielectric insulator 402 corresponding to the DSG, and the p-type substrate 102 corresponding to the DSG, as shown in Fig. 9.

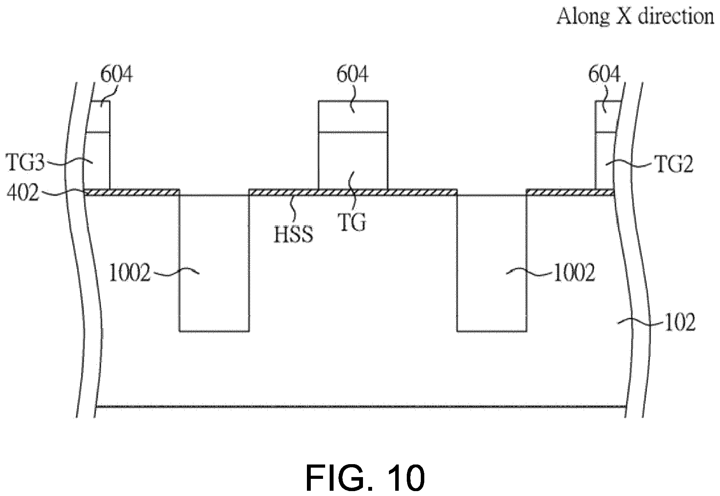

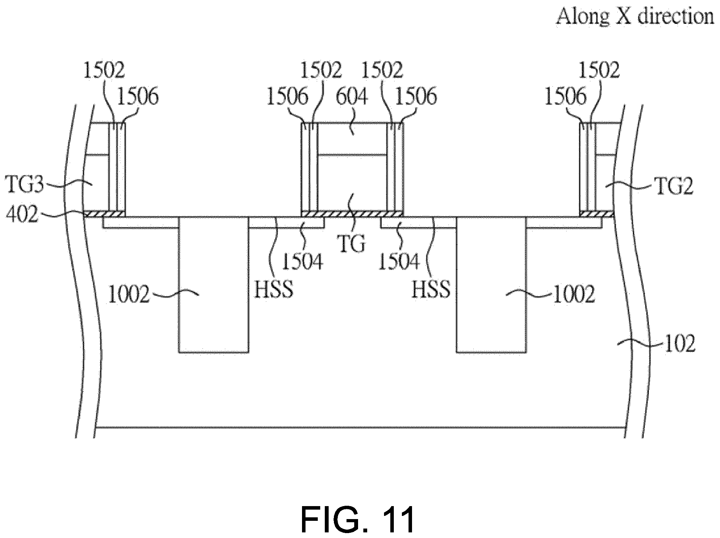

Furthermore, remove the gate mask layer 802, etch the SOD 702, and deposit a STI-oxide-2 1002 and then etch back, as shown in Fig. 10. Then, deposit and etch back an oxide-3 layer to form an oxide-3 spacer 1502, form the lightly Doped drains (LDDs) 1504 in the p-type substrate 102, deposit and etch back a nitride layer to form a nitride spacer 1506, and remove the dielectric insulator 402, as shown in Fig. 11.

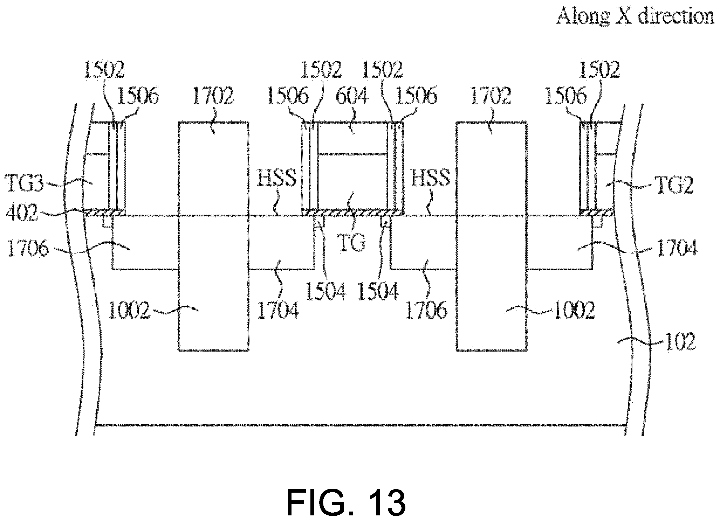

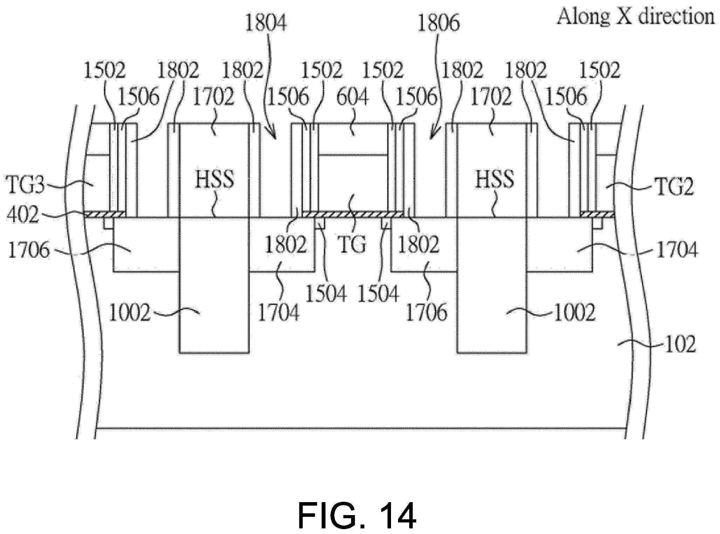

Moreover, utilize a selective epitaxy growth (SEG) technique to grow intrinsic silicon electrode 1602, as shown in Fig. 13. Then deposit and etch back a CVD-STI-oxide3 layer 1702, remove the intrinsic silicon 1602, and form a source region (n+ source) 1704 and a drain region (n+ drain) 1706 of the mMOSFET, as shown in Fig. 13. Since the source region (n+ source) 1704 and a drain region (n+ drain) 1706 are formed between the true gate (TG) and the CVD-STI-oxide3 layer 1702 the location of which is originally occupied by the dummy shield gate(DSG), thus, the length and width of the source region (n+ source) 1704 (or a drain region (n+ drain) 1706) is as small as λ. The opening of the source region (n+ source) 1704 (or a drain region (n+ drain) 1706) could be less than λ, such as 0.8λ. Such openings could be shrunk if further oxide spacer 1802 is formed, as shown in Fig. 14.

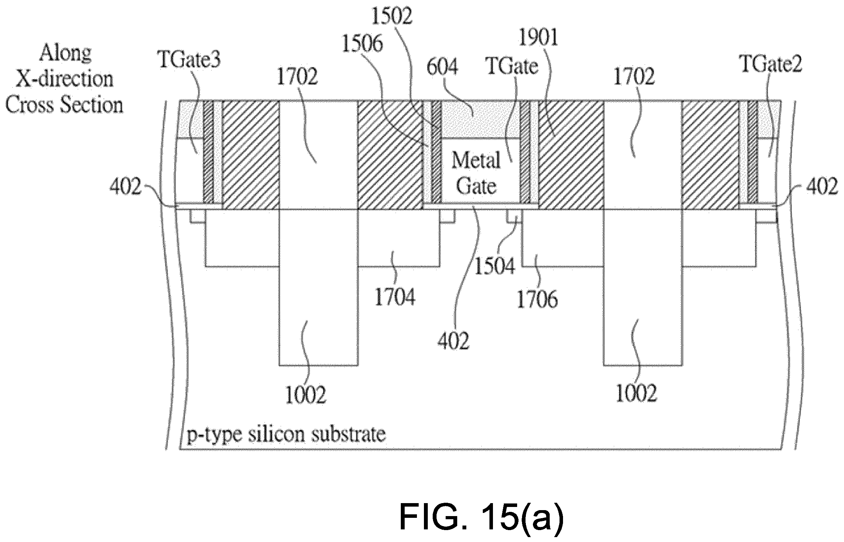

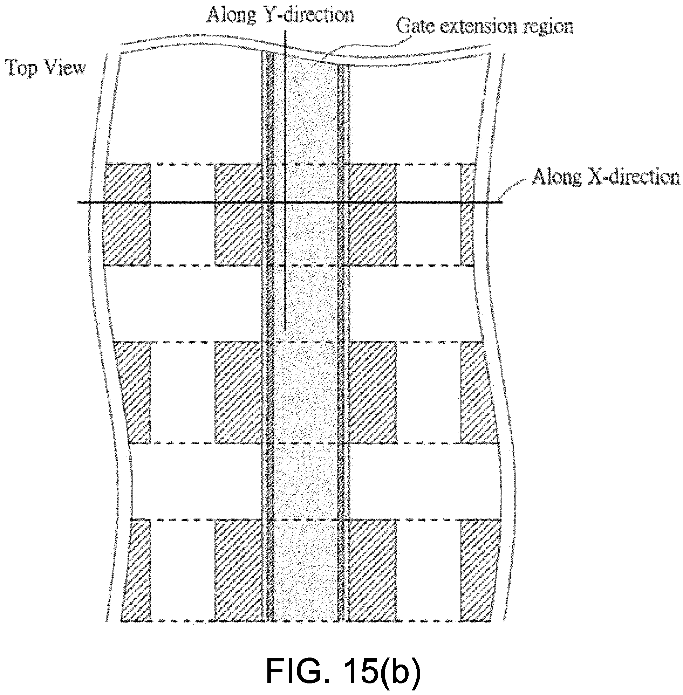

Additionally, the new SRAM structure makes the first metal interconnection (M1 layer) directly connect Gate, Source and/or Drain regions through self-aligned miniaturized contacts without using a conventional contact-hole-opening mask and/or an Metal-0 translation layer for M1 connections. Following Fig. 13, a layer of SOD 1901 is deposited to fill the vacancies on the substrate, including the openings of the source region (n+ source) 1704 (or a drain region (n+ drain) 1706). Then use CMP to make the surface flat, as shown in Fig. 15 (a). Figure 15(b) is the top view of the Fig. 15(a) and shows multiple fingers in horizontal direction.

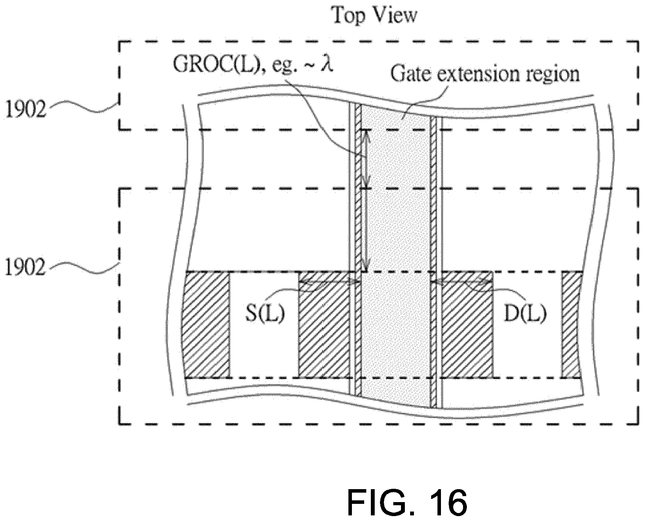

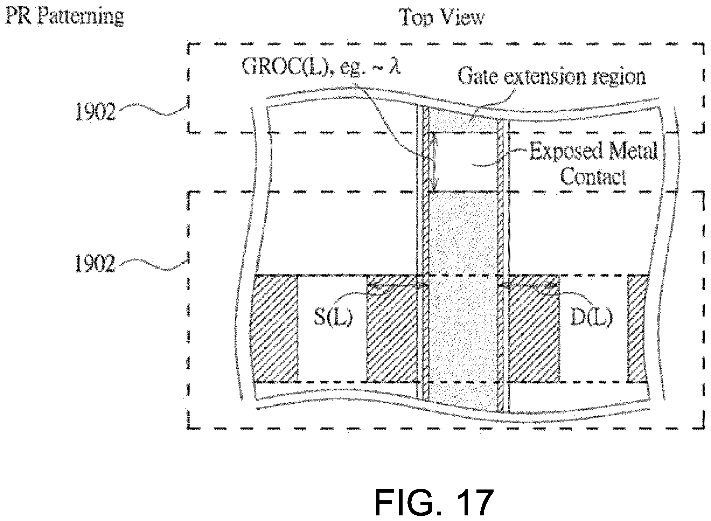

Furthermore, use a well-designed mask and carry out a photo resistance layer 1902 which results in some stripe pattern along the X-axis in Figure 15(b) with a separate space of the length GROC(L) to expose the area of gate extension region along the Y-axis in Figure 15(b), then the result is shown as a top view in Fig. 16. The most aggressive design rules with GROC(L) = λ, as shown in Fig. 16. Then use an anisotropic etching technique to remove the Nitride-cap layer within the exposed gate extension region to reveal the conductive Metal-gate layer (Fig. 17).

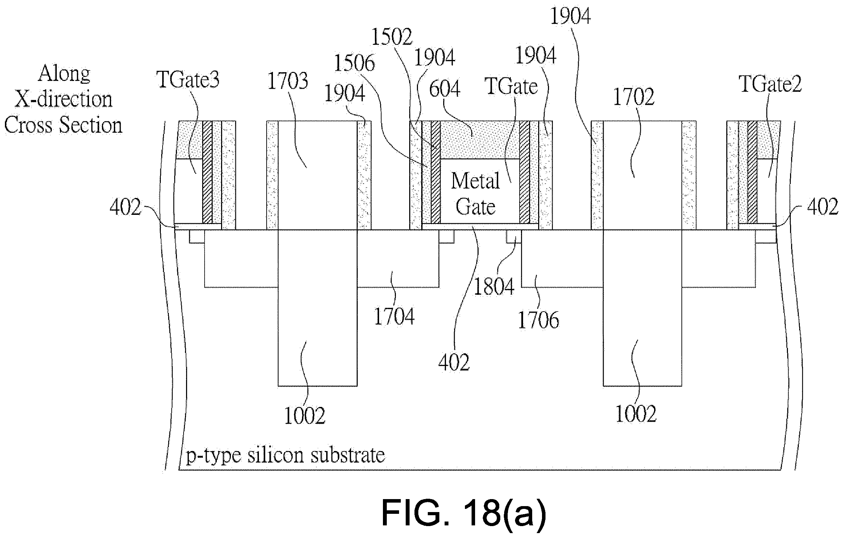

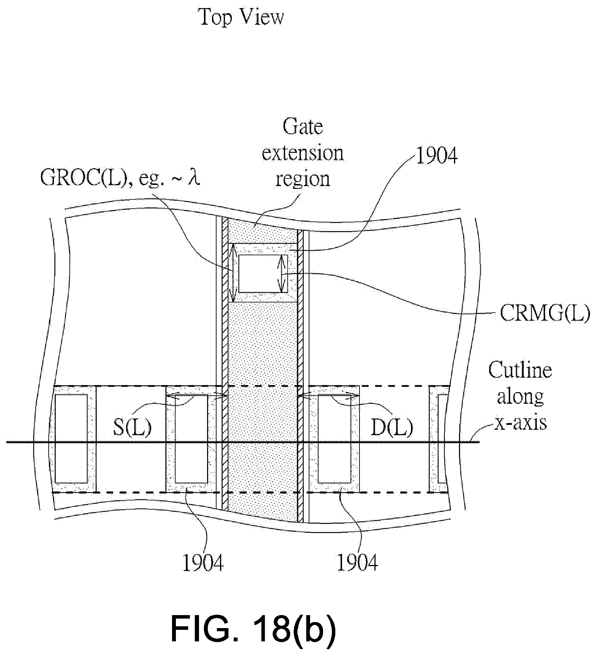

Thereafter, remove photo resistance layer 1902, and then remove the SOD layers 1901 so that those opening regions on top of both the source region 1704 and the drain region 1706 are revealed again. Then deposit a layer of Oxide 1904 with well-designed thickness and then use an anisotropic etching technique to form spacers on the four sidewalls in opening regions of the source region 1704 and the drain region 1706 and the exposed gate extension region 1903. Therefore, a natural built-up contact-hole opening is formed in the exposed gate extension region, the source region 1704 and the drain region 1706, respectively. Figure 18(a) shows the cross section of such transistor structure. Figure 18(b) shows top view of such a transistor structure in Fig. 18(a). The vertical length CRMG(L) of the opening in the exposed gate extension region 1903 is smaller than the length GROC(L) which could be λ.

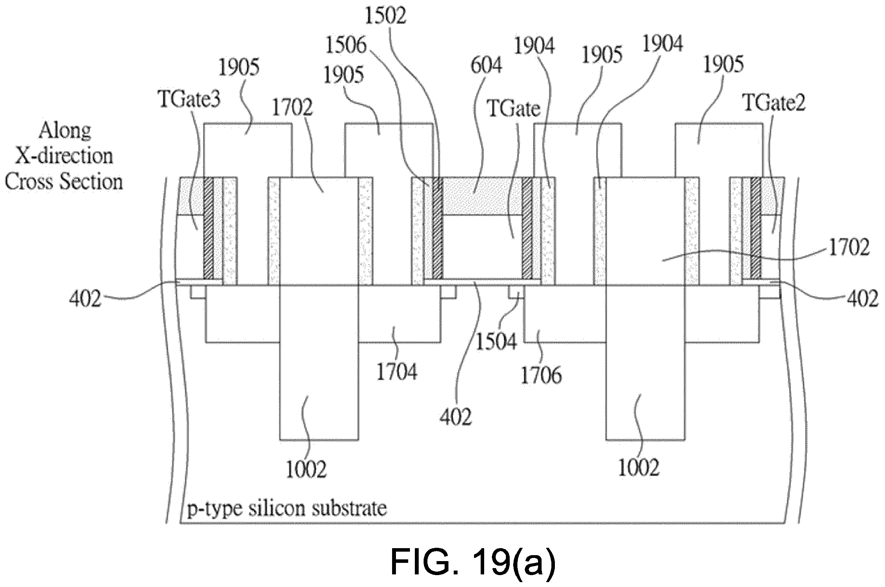

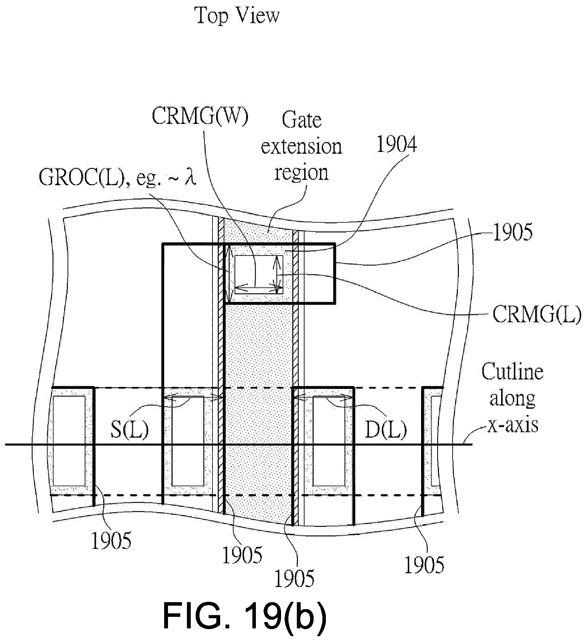

Finally, form a layer of Metal-1 1905 which has the well-designed thickness to fill in the holes of all the aforementioned contact-hole openings and result in a smooth planar surface following the topography of the wafer surface. Then use a photolithographic masking technique to create all the connections among those contact-hole openings respectively to achieve the necessary Metal-1 interconnection networks, as shown in Fig. 19(a). Fig. 19(b) is the top view of the mMOSFET shown in Fig. 19(a). So this Metal-1 layer complete the tasks of achieving both the contact-filling and the plug-connection to both Gate and Source/Drain functions as well as a direct interconnection function of connecting all transistors. There is no need to use an expensive and very rigidly controlled conventional contact-hole mask and carrying on the subsequent very difficult process of drilling the contact-hole openings, especially which should be the most difficult challenges in further scaling down the horizontal geometries of billions of transistors. In addition, it eliminates making both a metal plug into the contact-hole openings and a CMP process to achieve a Metal stud with complex integrated processing step (eg. as definitely required for some leading-edge technology of creating a Metal-Zero structure).

Moreover, as mentioned, the traditional 6T SRAM cell may not allow the Gate or Diffusion directly connect to M2 without bypassing the M1 structure. The present invention discloses a new SRAM structure in which either Gate or Diffusion (Source/Drain) areas to be directly connected to the M2 interconnection layer without a transitional layer M1 in a self-alignment way through one vertical conductive plug being composed of Contact-A and Via1-A which are respectively formed during the construction phases of making Contact and Via1 in the other locations on the same die. As results, the necessary space between one M1 interconnection and the other M1 interconnection and blocking issue in some wiring connections will be reduced. The following briefly describes a new SRAM structure in which the Gate and Diffusion (Source/Drain) areas is directly connected to the M2 interconnection layer without a transitional layer M1 in a self-alignment way.

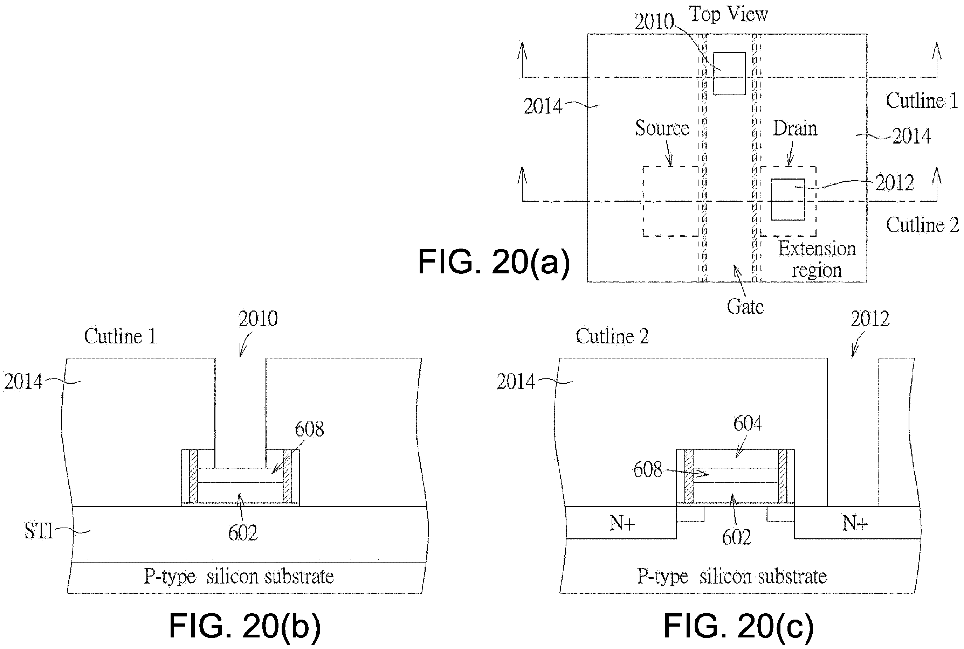

Figure 20 shows the cross sections and the top view of a transistor of the new 6T SRAM up to its constructed phase of making multiple opening-holes on top of both gate extension region and Diffusion region, wherein Fig. 20(a) is a top view of the constructed phase of the transistor, and Figs. 20(b) and 20(c) are two cross sections of the constructed phase of the transistor along Cutline 1 and Cutline 2 shown in Fig. 20(a), respectively. Similar to Fig. 17 and Fig. 18 (b), opening-holes 2010 and 2012 are formed on top of both the gate extension region and Drain region, respectively. Surrounding these opening-holes 2010 and 2012 are all insulators 2014 (eg. oxide or low-k dielectric). One of major differences is that, the gate extension region further includes a silicon region 608, and the silicon region 608 could be part of the poly-silicon gate when the poly-silicon gate is used as gate conductor 602, or the silicon region 608 could be a layer formed on the gate metal when the gate metal is used as the gate conductor 602. As shown in Fig. 20(c), the gate extension region further includes a nitride layer 604 over the silicon region 608. As shown in Fig. 20(b), the opening-holes 2010 reveals the silicon region 608 at least by etching portion of the nitride layer 604.

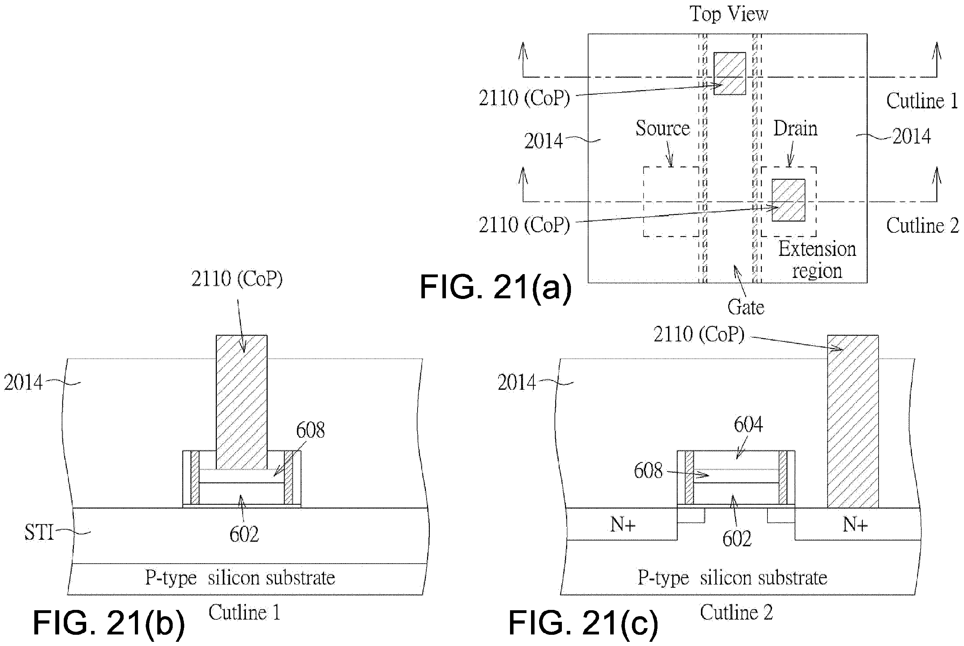

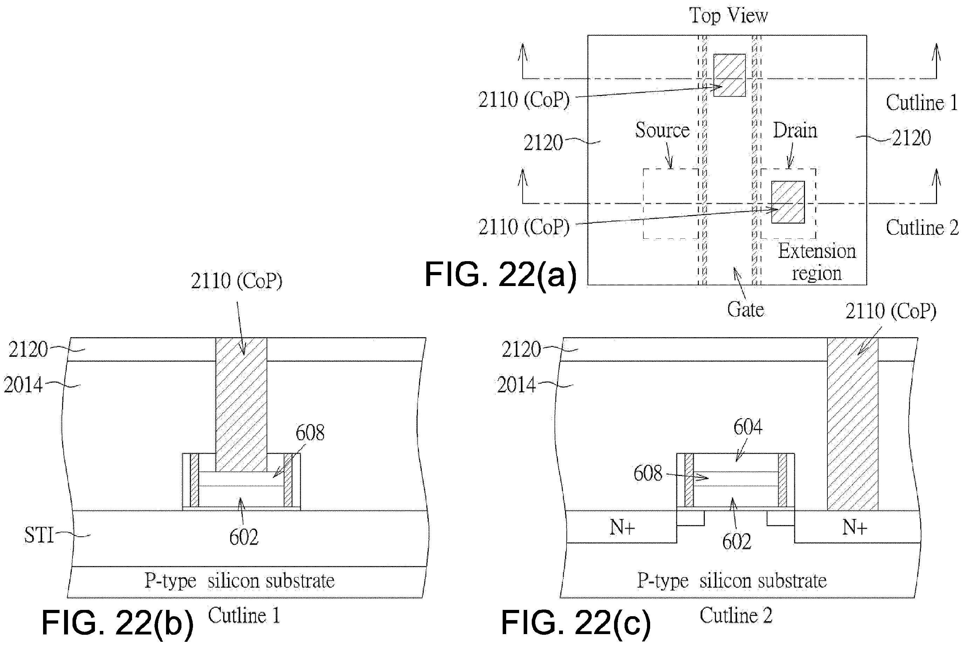

After that, use a Selective Epitaxy Growth Technique (SEG) (or Selective Atomic Layer Deposition Technique) to grow heavily doped conductive silicon plug 2110, called as conductor pillar (CoP) as shown in Fig. 21 (Fig. 21(a) is a top view of this constructed phase of the transistor, and Figs. 21(b) and 21(c) are two cross sections of this constructed phase of the transistor along Cutline 1 and Cutline 2 shown in Fig. 21(a), respectively). Then either an oxide layer or low-k dielectric layer 2120 is deposited to a height which is taller than these conductor pillars 2110. Then use either CMP (Chemical Mechanical Polishing) or Etch-Back technique to achieve a planar wafer surface, as shown in Fig. 22 (Fig. 22(a) is a top view of this constructed phase of the transistor, and Figs. 22(b) and 22(c) are two cross sections of this constructed phase of the transistor along Cutline 1 and Cutline 2 shown in Fig. 22(a), respectively). Those "Exposed Heads" of Conductor Pillars (CoP) 2110 form very useful landing pads (LPad) for the subsequent connection formation between metal interconnections and the conductor pillars (CoP) 2110 which connect either the gate or drain regions, respectively.

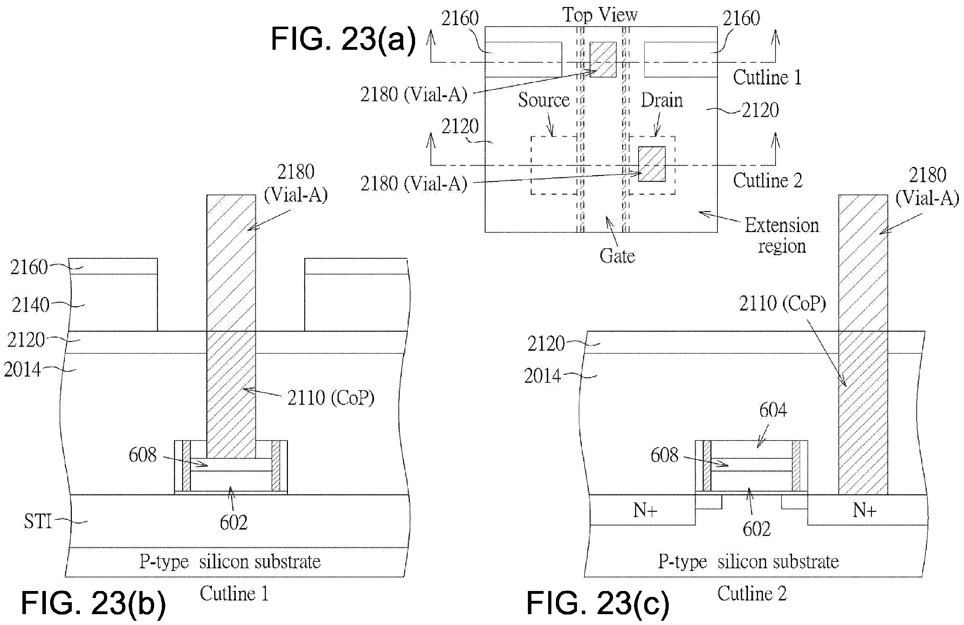

Furthermore, deposit a metal M1 layer 2140 and a thin oxide layer 2160 on top of the metal M1 layer 2140. Use a photolithographic masking technique, a suitable oxide removal technique and then an metal etching technique to define the designed patterns for metal M1 interconnections. Here the specific conductor pillar areas which are designed for connecting either gate or drain region, respectively, later directly to the following metal M2 layer are not covered by the metal M1 layer 2140 but exposed again with their heads of the conductor pillar (CoP) 2110. By using these exposed heads of the conductor pillar (CoP) 2110, a heavily doped silicon pillars (CoP2) 2180 can be grown on top of them, and those heavily doped silicon pillars (CoP2) 2180 will be used exactly as Via1-A, as shown in Fig. 23 (Fig. 23(a) is a top view of this constructed phase of the transistor, and Figs. 23(b) and 23(c) are two cross sections of this constructed phase of the transistor along Cutline 1 and Cutline 2 shown in Fig. 23(a), respectively).

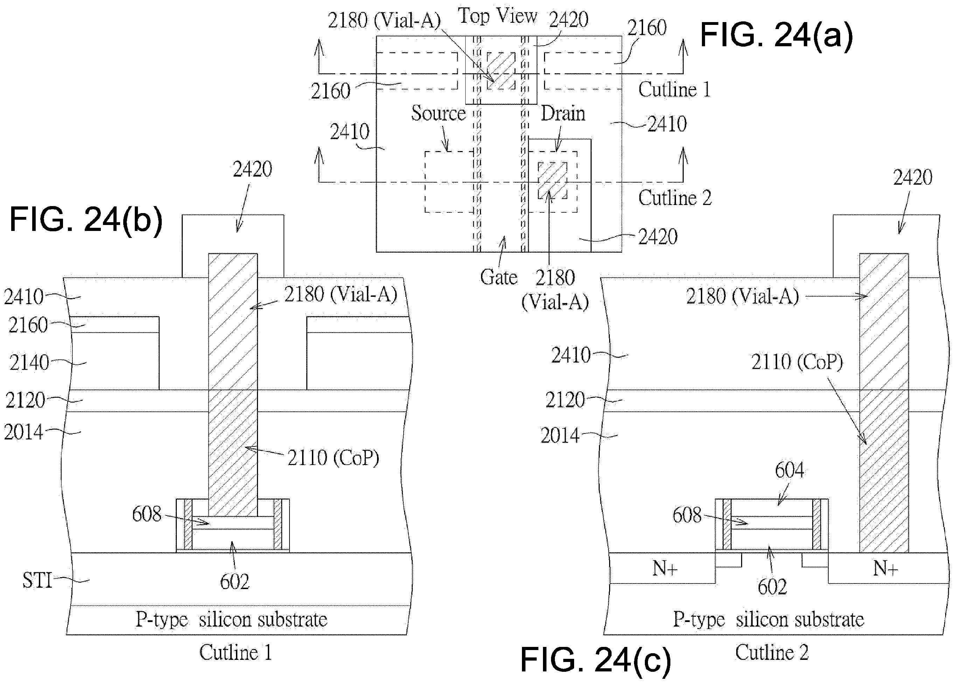

Then a layer of either oxide or low-k dielectric 2410 is deposited with its thickness enough for isolation between the metal M1 layer 2140 and the following metal layer. The thickness of this dielectric layer 2410 can be made somewhat lower than the height of the doped silicon pillars (CoP2) 2180 so that some exposed areas can be used naturally as Via conductors (called as Via1-A). A Metal M2 layer 2420 is then deposited and defined by a photolithographic masking technique to complete metal M2 interconnections. Thus, it is realized to have created a direct connection between the metal M2 layer and either Gate or Diffusion regions, respectively, that is, M2-Via1.A-CoP-Gate or M2-Via1.A-CoP-Drain (or Source), as shown in Fig. 24 (Fig. 24(a) is a top view of this constructed phase of the transistor, and Figs. 24(b) and 24(c) are two cross sections of this constructed phase of the transistor along Cutline 1 and Cutline 2 shown in Fig. 24(a), respectively). Of course, based on this embodiment, it is possible that there are other metal layer(s) or dielectric layer(s) existing between the first metal layer and the second metal layer, and the conductor pillar could connect to the second metal layer but disconnect from the first metal layer and other metal layer(s).

Additionally, the present invention discloses a new SRAM structure in which the n+ and p+ regions of the source and drain regions in the NMOS and PMOS transistors respectively are fully isolated by insulators, such insulators would not only increase the immunity to Latch-up issue, but also increase the isolation distance into silicon substrate to separate junctions in NMOS and PMOS transistors so that the surface distance between junctions can be decreased (such as 3λ), so is the size of the SRAM. The following briefly describes a new SRAM structure in which the n+ and p+ regions of the source and drain regions in the NMOS and PMOS transistors respectively are fully isolated by insulators. The detailed description for the new combination structure of the PMOS and MNOS is presented in the US Patent Application No. 17/318,097, field on May 12, 2021 and entitled "COMPLEMENTARY MOSFET STRUCTURE WITH LOCALIZED ISOLATIONS IN SILICON SUBSTRATE TO REDUCE LEAKAGES AND PREVENT LATCH-UP", and the whole content of the US Patent Application No. 17/318,097 is incorporated by reference herein.

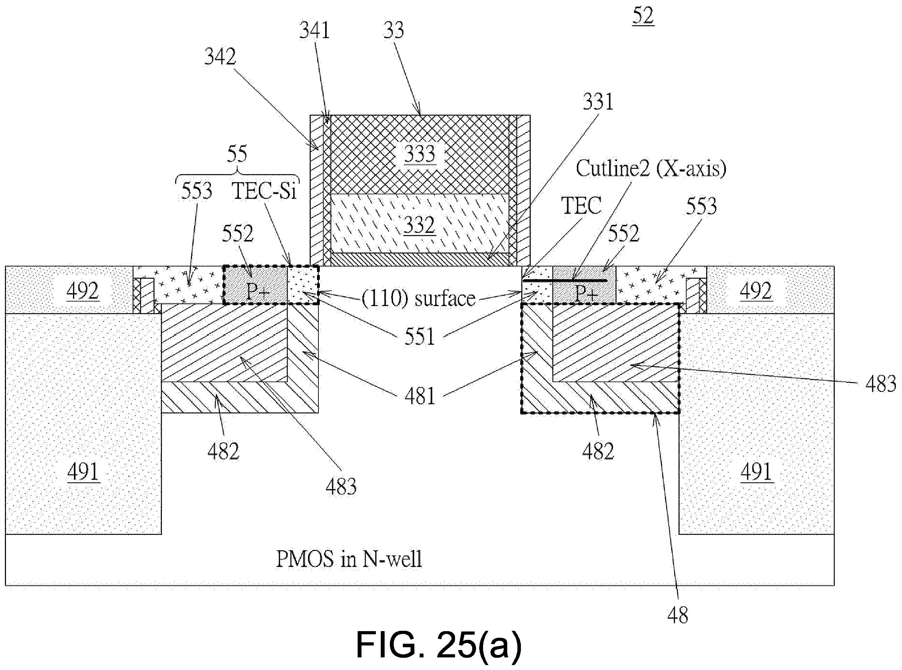

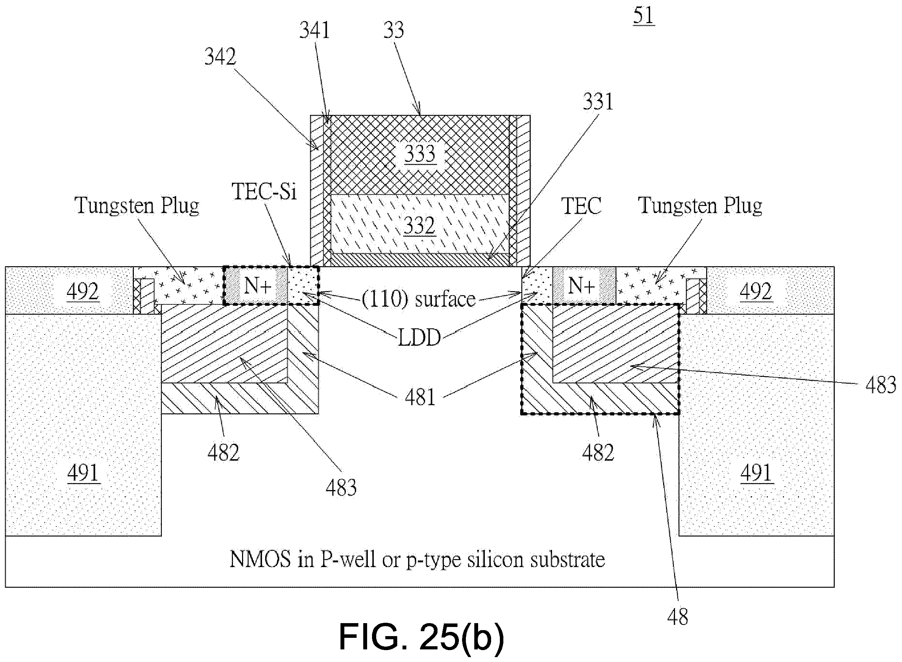

Please refer to Figs. 25(a) and 25(b). Fig. 25(a) is a diagram illustrating a cross section of the PMOS transistor 52, and Fig. 25(b)is a diagram illustrating a cross section of the NMOS transistor 51. The gate structure 33 comprising a gate dielectric layer 331 and gate conductive layer 332 (such as gate metal) is formed above the horizontal surface or original surface of the semiconductor substrate (such as silicon substrate). A dielectric cap 333 (such as a composite of oxide layer and a Nitride layer) is over the gate conductive layer 332. Furthermore, spacers 34 which may include a composite of an oxide layer 341 and a Nitride layer 342 is used to over sidewalls of the gate structure 33. Trenches are formed in the silicon substrate, and all or at least part of the source region 35 and drain region 36 are positioned in the corresponding trenches, respectively. The source (or drain) region in the PMOS transistor 32 may include P+ region or other suitable doping profile regions (such as gradual or stepwise change from P- region and P+ region). Furthermore, a localized isolation 48 (such as nitride or other high-k dielectric material) is located in one trench and positioned under the source region, and another localized isolation 48 is located in another trench and positioned under the drain region. Such localized isolation 48 is below the horizontal silicon surface (HSS) of the silicon substrate and could be called as localized isolation into silicon substrate (LISS) 48. The LISS 48 could be a thick Nitride layer or a composite of dielectric layers. For example, the localized isolation or LISS 48 could comprise a composite localized isolation which includes an oxide layer (called Oxide-3V layer 481) covering at least a portion sidewall of the trench and another oxide layer (Oxide-3B layer 482) covering at least a portion bottom wall of the trench. The Oxide-3V layer 481 and Oxide-3B layer 482 could be formed by thermal oxidation process. The composite localized isolation 48 further includes a nitride layer 483 (called as Nitride-3) being over the Oxide-3B layer 482 and contacting with the Oxide-3V layer 481. It is mentioned that the nitride layer 483 or Nitride-3 could be replaced by any suitable insulation materials as long as the Oxide-3V layer remains most as well as being designed. Furthermore, the STI (Shallow Trench Isolation) region in Figs. 25(a) and 25(b) could comprise a composite STI 49 which includes a STI-1 layer 491 and a STI-2 layer 492, wherein the STI-1 layer 491 and a STI-2 layer 492 could be made of thick oxide material by different process, respectively.

Moreover, the source (or drain) region in Figs. 25(a) and 25(b) could comprise a composite source region 55 and/or drain region 56. For example, as shown in Fig. 25(a), in the PMOS transistor 52, the composite source region 55 (or drain region 56) at least comprises a lightly doped drain (LDD) 551 and a heavily P+ doped region 552 in the trench. Especially, it is noted that the lightly doped drain (LDD) 551 abuts against an exposed silicon surface with a uniform (110) crystalline orientation. The exposed silicon surface has its vertical boundary with a suitable recessed thickness in contrast to the edge of the gate structure, which is labeled in Fig. 25(a) as TEC (Thickness of Etched-away Transistor-body Well-Defined to be the Sharp Edge of Effective Channel Length). The exposed silicon surface is substantially aligned with the gate structure. The exposed silicon surface could be a terminal face of the channel of the transistor.

The lightly doped drain (LDD) 551 and the heavily P+ doped region 552 could be formed based on a Selective Epitaxial Growth (SEG) technique (or other suitable technology which may be Atomic Layer Deposition ALD or selective growth ALD - SALD) to grow silicon from the exposed TEC area which is used as crystalline seeds to form new well-organized (110) lattice across the LISS region which has no seeding effect on changing (110) crystalline structures of newly formed crystals of the composite source region 55 or drain region 56. Such newly formed crystals (including the lightly doped drain (LDD) 551 and the heavily P+ doped region 552) could be named as TEC-Si, as marked in Fig. 25(a). In one embodiment, the TEC is aligned or substantially aligned with the edge of the gate structure 33, and the length of the LDD 551 is adjustable, and the sidewall of the LDD 551 opposite to the TEC could be aligned with the sidewall of the spacer 34. Similarly, the TEC-Si (including the LDD region and the heavily N+ doped region) of the composite source/drain region for the NMOS transistor 51 is shown in Fig. 25(b). The composite source (or drain) region could further comprise some Tungsten (or other suitable metal materials) plugs 553 formed in a horizontal connection to the TEC-Si portion for completion of the entire source/drain regions, as shown in Figs. 25(a) and 25(b). As shown in Fig. 25(a), the active channel current flowing to future Metal interconnection such as Metal-1 layer is gone through the LDD 551 and heavily-doped conductive region 552 to Tungsten 553 (or other metal materials) which is directly connected to Metal-1 by some good Metal-to-Metal Ohmic contact with much lower resistance than the traditional Silicon-to-Metal contact.

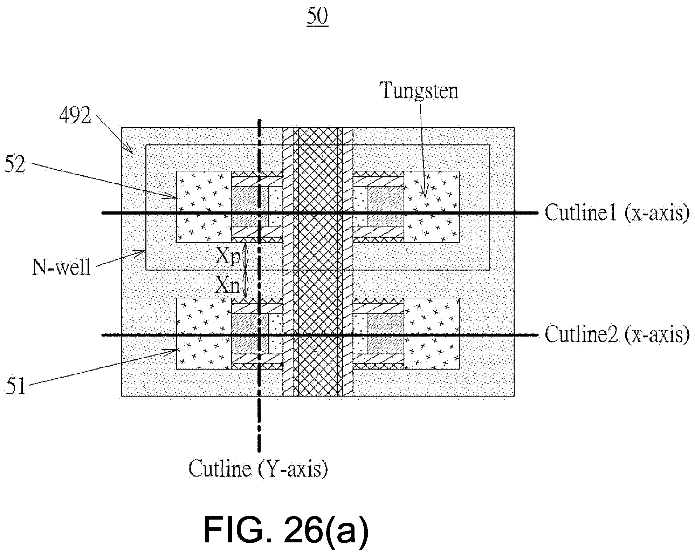

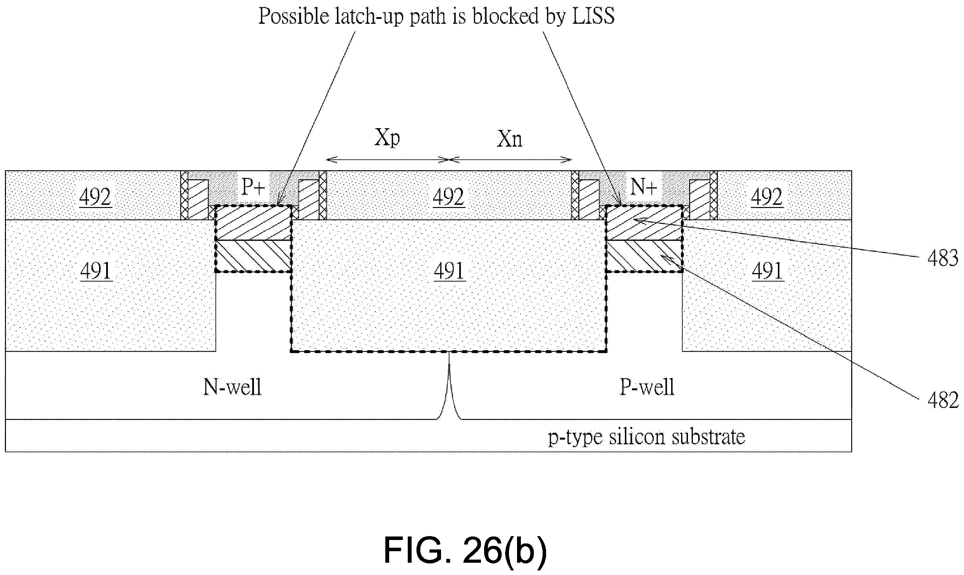

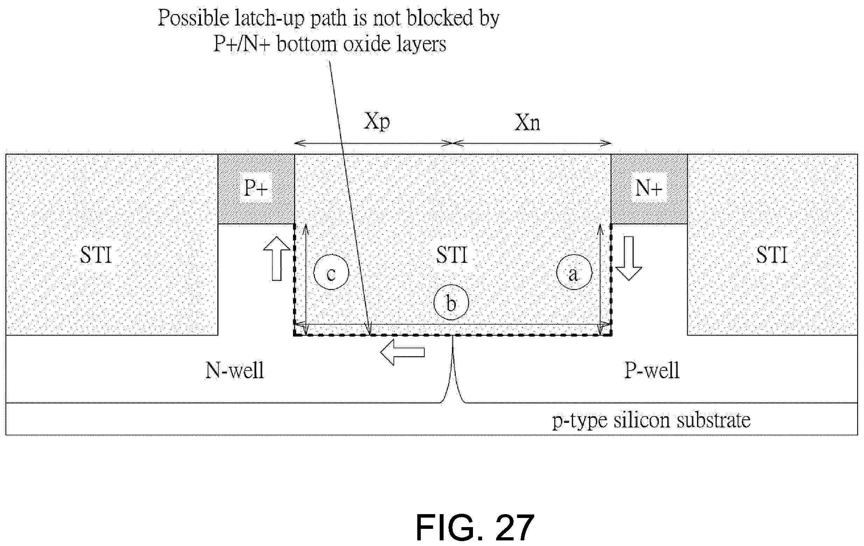

One combination structure of the new PMOS 52 and new NMOS 51 is shown in Fig. 26(a) which is a top view, and Fig. 26(b)is a diagram illustrating a cross section of the combination of the new PMOS 52 and new NMOS 51 along the cutline (Y-axis) in FIG. 26(a). As shown in Fig. 26(b), there exists a composite localized isolation (or the LISS 48) between the bottom of the P+ source/drain region of the PMOS and the n-type N-well, so is another composite localized isolation (or the LISS 48) between the bottom of the N+ source/drain region of the NMOS and the p-type P-well or substrate. The advantage is clearly shown that the bottom of the n+ and p+ regions are fully isolated by insulators in this newly invented CMOS structure shown in FIG. 26(b), that is, the possible latch-up path from the bottom of the P+ region of the PMOS to the bottom of the N+ region of the NMOS is totally blocked by the LISS. On the other hand, in the traditional CMOS structure the n+ and p+ regions are not fully isolated by insulators as shown in FIG.27, the possible Latch-up path exists from the n+/p junction through the p-well/n-well junction to the n/p+ junction includes the length○,a, the length○,b, and the length○,c (FIG. 27). Thus, from device layout point of view, the reserved edge distance (Xₙ+Xₚ) between NMOS and PMOS in Fig. 26(b) could be smaller than that in Fig. 27. For example, the reserved edge distance (Xₙ+Xₚ) could be around 2~4λ, such as 3λ.

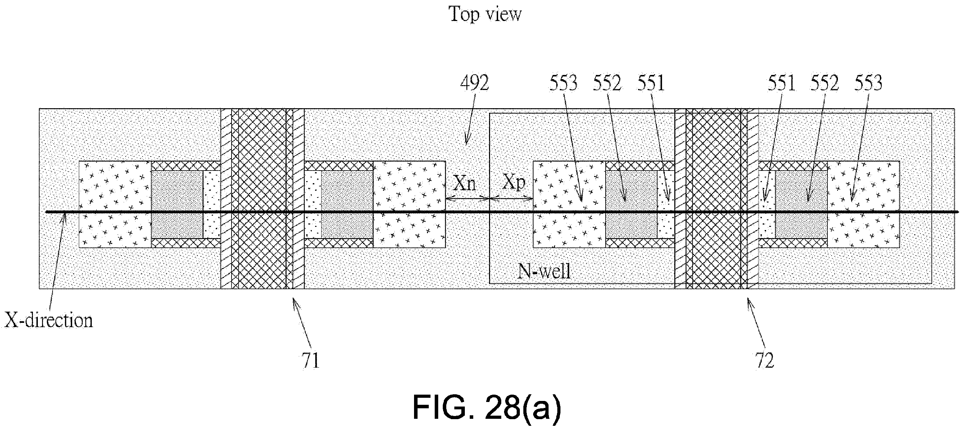

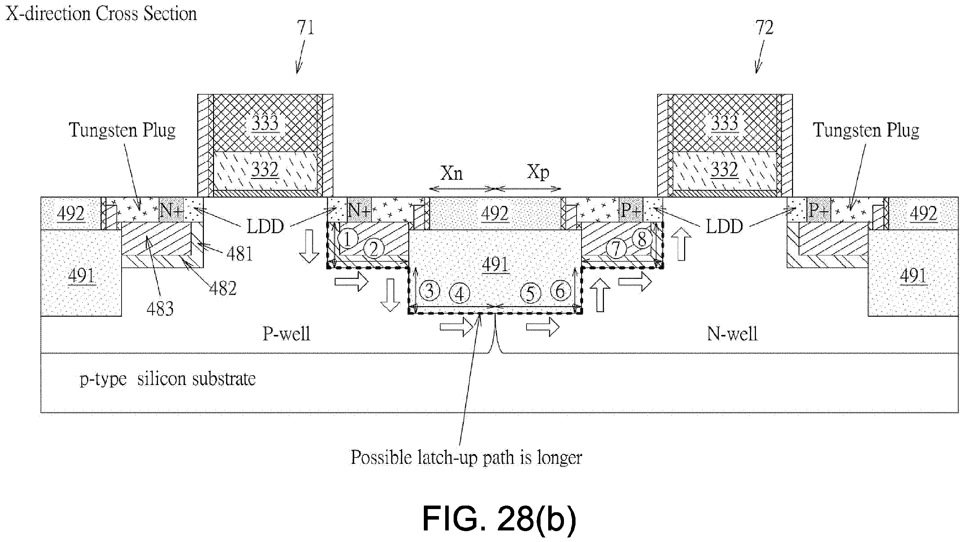

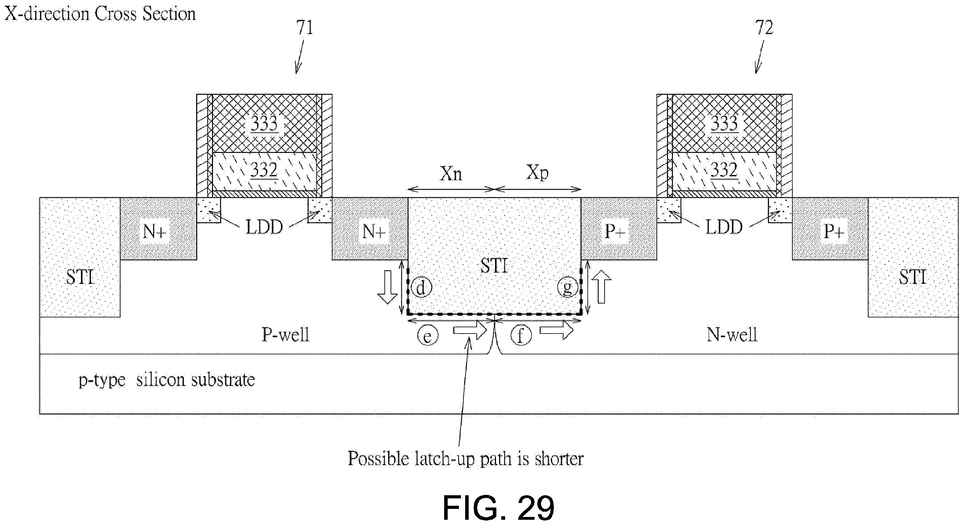

The other combination structure of the new PMOS 52 and new NMOS 51 is shown in Fig. 28(a) which is a top view, and Fig. 28(b) is a diagram illustrating a cross section of the combination of the new PMOS 52 and new NMOS 51 along the cutline (X-axis) in FIG. 28(a). As shown in Fig. 28(b), it results in a much longer path from the n+/p junction through the p-well (or p-substrate)/n-well junction to the n/p+ junction. The possible Latch-up path from the LDD-n/p junction through the p-well /n-well junction to the n/LDD-p junction includes the length ①, the length ②(the length of the bottom wall of one LISS region), the length ③, the length ④, the length ⑤, the length ⑥, the length ⑦ (the length of the bottom wall of another LISS region), and the length ⑧ marked in Fig. 28(b). On the other hand, in traditional CMOS structure which combines PMOS and NMOS structure shown in Fig. 29, the possible Latch-up path from the n+/p junction through the p-well/n-well junction to the n/p+ junction just includes the length ○,d, the length ○,e, the length ○,f, and the length ○,g (as shown in Fig. 29). Such possible Latch-up path of Fig. 28(b) is longer than that in Fig. 29. Therefore, from device layout point of view, the reserved edge distance (Xₙ+Xₚ) between NMOS and PMOS in Fig. 28(b) could be smaller than that in Fig. 29. For example, the reserved edge distance (Xₙ+Xₚ) could be around 2~4λ, such as 3λ.

Furthermore, in traditional SRAM, the metal wires for high level voltage VDD and low level voltage VSS (or Ground) are distributed above the original silicon surface of the silicon substrate, and such distribution will interfere with other metal wires for the word-line (WL), bit-lines (BL and BL Bar), or other connection metal lines if there is no enough spaces among those metal wires. The present invention discloses a new SRAM structure in which the metal wires for high level voltage VDD and/or the low level voltage VSS could be distributed under the original silicon surface of the silicon substrate, thus, the interference among the size of the contacts, among layouts of the metal wires connecting the word-line (WL), bit-lines (BL and BL Bar), high level voltage VDD, and low level voltage VSS, etc. could be avoided even the size of the SRAM cell is shrunk. As shown in Fig. 27, in the drain region of the PMOS 52, the Tungsten or other metal materials 553 is directly coupled to the Nwell which is electrically coupled to VDD. On the other hand, in the source region of the NMOS 51, the Tungsten or other metal materials 553 is directly coupled to the Pwell or P-substrate which is electrically coupled to Ground. Thus, the openings for the source/drain regions which are originally used to electrically couple the source/drain regions with metal layer 2 or metal layer 3 for VDD or Ground connection could be omitted in the new SRAM structure. The detailed description for the structure of the aforesaid structure and the manufacture process thereof is presented in the US Patent Application No. 16/991,044, filed on Aug. 12, 2020 and entitled: "TRANSISTOR STRUCTURE AND RELATED INVERTER", and the whole content of the US Patent Application No. 16/991,044 is incorporated by reference herein.

To sum up, at least there are following advantages in the new 6T SRAM cell:
(1) The linear dimensions of the source, the drain and the gate of the transistors in the SRAM are precisely controlled, and the linear dimension can be as small as the minimum feature size, Lamda (λ). Therefore, when two adjacent transistors are connected together through the drain/source, the length dimension of the transistor would be as small as 3λ, and the distance between the edges of the gates of the two adjacent transistors could be as small as 2λ. Of course, for tolerance purpose, the length dimension of the transistor would be around 3λ~4λ.
(2) The first metal interconnection (M1 layer) directly connect Gate, Source and/or Drain regions through self-aligned miniaturized contacts without using a conventional contact-hole-opening mask and/or an Metal-0 translation layer for M1 connections.
(3) The Gate and/or Diffusion (Source/Drain) areas are directly connected to the M2 interconnection layer without a transitional layer M1 in a self-alignment way. Therefore, the necessary space between one M1 interconnection and the other M1 interconnection and blocking issue in some wiring connections will be reduced.
(4) The n+ and p+ regions of the source and drain regions in the NMOS and PMOS transistors respectively are fully isolated by insulators, such insulators would not only increase the immunity to Latch-up issue, but also increase the isolation distance into silicon substrate to separate junctions in NMOS and PMOS transistors so that the surface distance between junctions can be decreased (such as 3λ), so is the size of the SRAM.
(5) The metal wires for high level voltage VDD and/or the low level voltage VSS in the SRAM cell could be distributed under the original silicon surface of the silicon substrate, thus, the interference among the size of the contacts, among layouts of the metal wires connecting the word-line (WL), bit-lines (BL and BL Bar), high level voltage VDD, and low level voltage VSS, etc. could be avoided even the size of the SRAM cell is shrunk. Moreover, the openings for the source/drain regions which are originally used to electrically couple the source/drain regions with metal layer 2 or metal layer 3 for VDD or Ground connection could be omitted in the new SRAM structure.

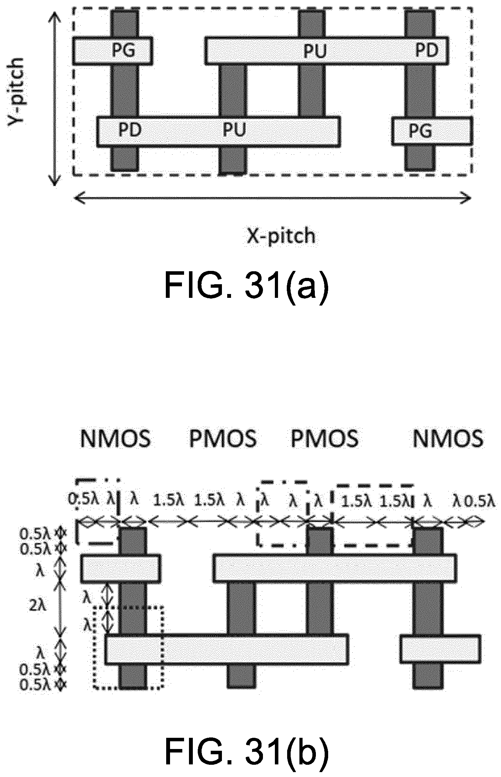

Fig. 31(a) is a copy of Fig. 2 shows the "stick diagram" representing the layout and connection among the 6 transistors of the SRAM, and Fig. 31(b) is a stick diagram of the new 6T SRAM with dimension according to the advantages of the new 6T SRAM structure. As shown in Fig. 31(b), the dimension of the transistor would be as small as 3λ (marked by dot rectangle), and the distance between the edges of the gates of the two adjacent transistors could be as small as 2λ. Furthermore, the isolation distance into silicon substrate to separate junctions in NMOS and PMOS transistors can be decreased as small as 3λ (marked by dash rectangle). The isolation distance into silicon substrate to separate junctions in two PMOS transistors can be decreased between 1.5~2.5λ, such as small as 2λ(marked by one dot-dash rectangle).

In Fig. 31(b), the dimension of the active region (vertical line) can be as small as λ, so is the gate line (horizontal line). Furthermore, in Fig. 31(b), for the transistor in the upper left corner which is corresponding to the PG transistor in Fig. 31(a), in order to avoid the interference between two contact holes which will be formed later in the action region and the gate region respectively, the horizontal distance between the edge of the active region and the boundary of the SRAM cell or bit cell will be 1.5λ (marked by two dots-dash rectangle). So is the transistor in the bottom right corner of Fig. 31(b) which is corresponding to another PG transistor in Fig. 31(a). Thus, for the stick diagram in Fig. 31(b), the horizontal length (x-direction) of the SRAM cell or bit cell is 15λ, and the vertical length (y-direction) of the SRAM cell or bit cell is 6λ. Therefore, the total area of the SRAM cell or bit cell of the Fig. 31(b) is 90λ².

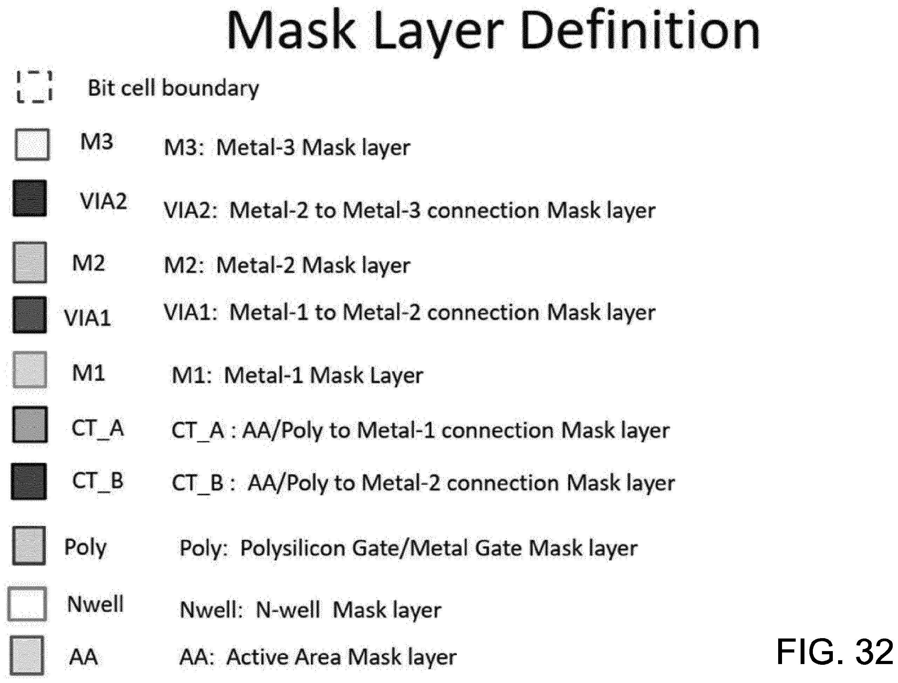

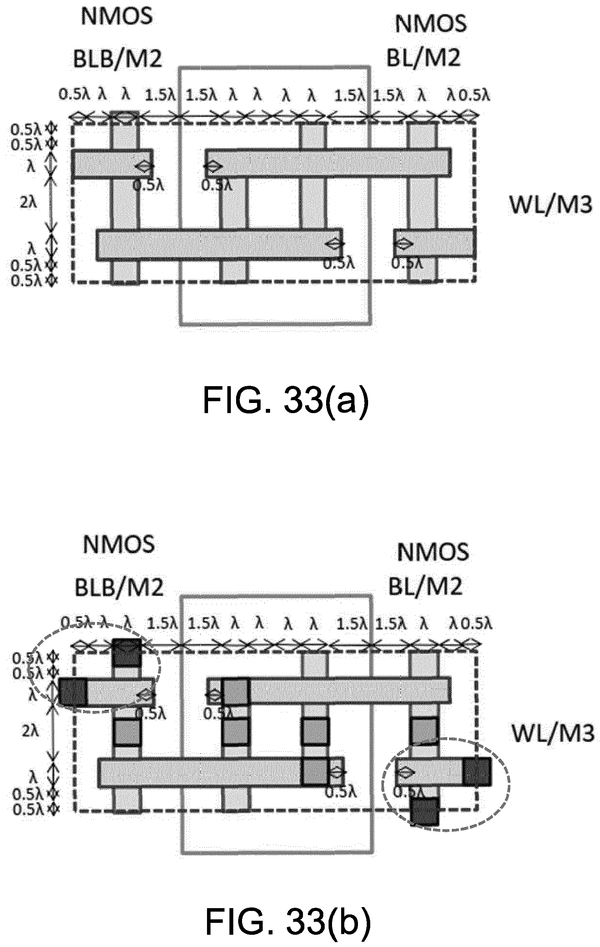

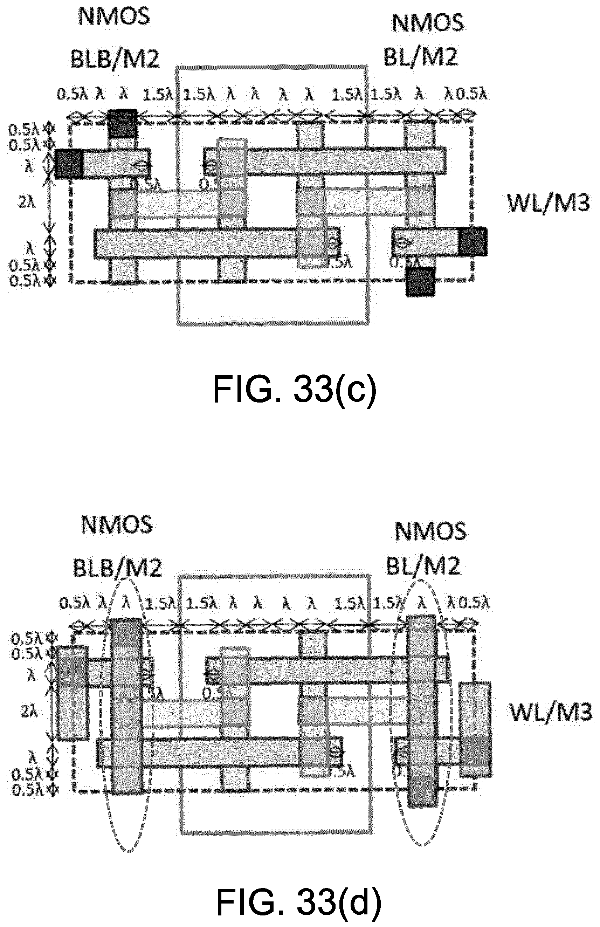

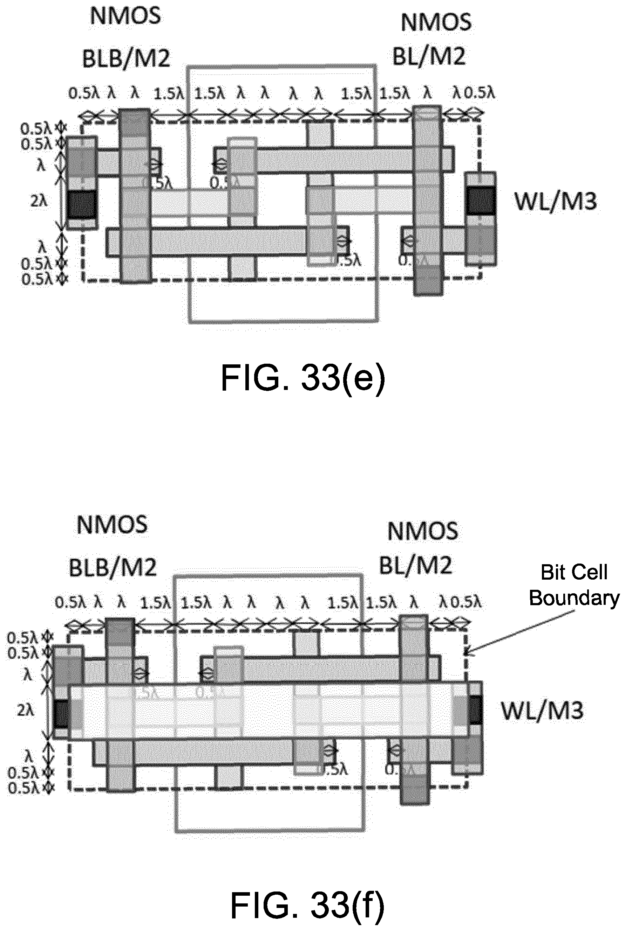

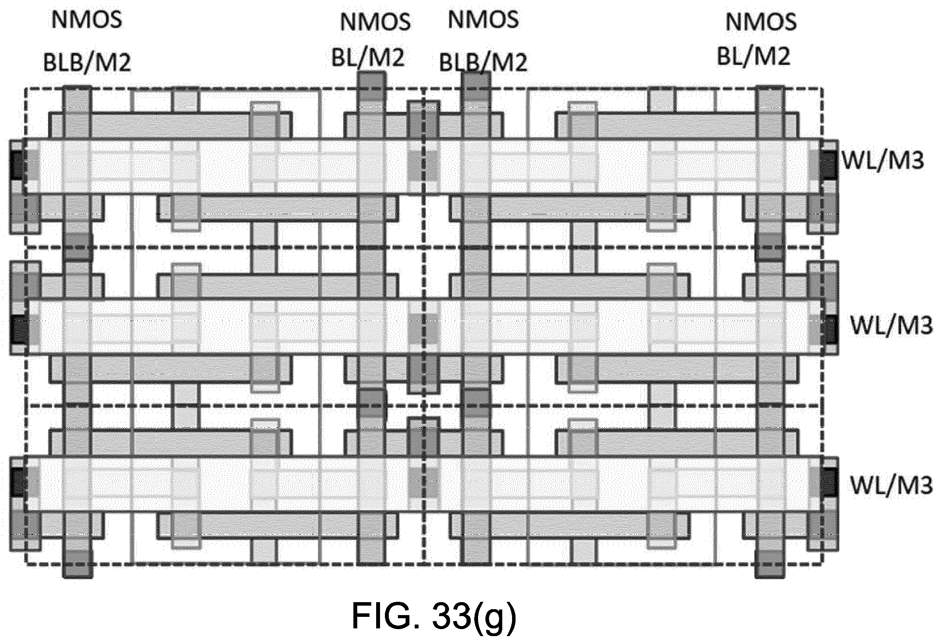

Using the stick diagram in Fig. 31(b) as a template, at least five SRAM cell structures are proposed in the present invention as shown in Figs. 32~37. Fig. 32 is the definition for different mask layers used in Figs. 33~37, wherein the meaning of the abbreviated symbols are as follows:

| Bit cell boundary | The boundary of the area of the single SRAM cell. |
|---|---|
| M3 | The Metal-3 Mask layer |
| VIA2 | The VIA Mask layer for connecting the Metal-2 layer to the Metal-3 layer |
| M2 | The Metal-2 Mask layer |
| VIA1 | The VIA Mask layer for connecting the Metal-1 layer to the Metal-2 layer |
| M1 | The Metal-1 Mask layer |
| CT_A | Opening VIA Mask layer for connecting AA (or Poly) to the Metal-1 layer, wherein "AA" means the active region (source or drain), and "Poly" means gate region. |
| CT_B | Opening VIA Mask layer for connecting AA (or Poly) directly to the Metal-2 layer |
| Poly | The Mask layer for Polysilicon Gate or Metal Gate |
| AA | The Mask layer for Active Area (such as drain region or source region) |
| Nwell | The N-well Mask area for N-well |
| WL | Word-line |
| BL/BLB | Bit line/Bit line Bar |
| Vdd | Vdd voltage source |
| Vss | Vss voltage source |

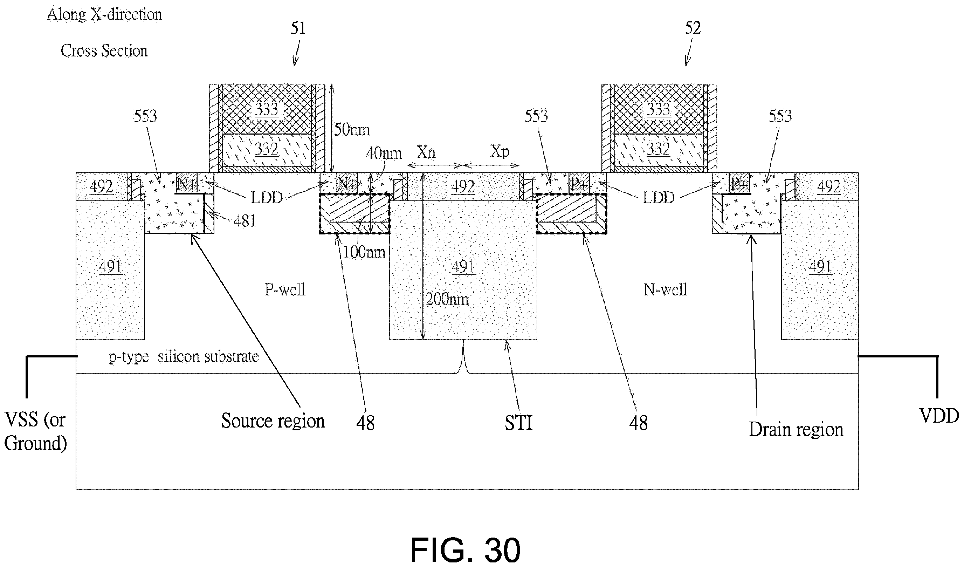

As shown in Fig. 33(a) which is a copy of Fig. 31(b), the area of the SRAM cell in this embodiment is 90λ². In Fig. 33(b), a plurality of CT_A (Opening VIA Mask layer for connecting AA (or Poly) to the Metal-1 layer) and CT_B (Opening VIA Mask layer for directly connecting AA (or Poly) to the Metal-2 layer, as marked by dash ovals) are formed. In Fig. 33(c), the Metal-1 Mask layers (M1) are formed to connect the plurality of CT_A, however, the plurality of CT_B do not connect to the Metal-1 Mask layers (M1). In Fig. 33(d), the Metal-2 Mask layers (M2) are formed at least to connect the plurality of CT_B. Some of the Metal-2 Mask layers (M2) are used as bit line (BL) and bit line bar (BLB), as marked by two dash ovals. In Fig. 33(e), a plurality of VIA2 are formed, and in Fig. 3(f) the Metal-3 Mask layer (M3) is formed to connect the plurality of VIA2, and the Metal-3 Mask layer (M3) is used as the word line (WL). Fig. 33(g) shows 6 SRAM cells of the present invention are arranged in a two dimensional array. In this embodiment, there is no VIA1, and the metal wires for high level voltage VDD and/or the low level voltage VSS in the SRAM cell are distributed under the original silicon surface of the silicon substrate, as shown in Fig. 30. Additionally, as shown in Fig. 33(c), the Metal-1 Mask layers (M1) directly connects gate, source and/or drain regions through without using a conventional contact-hole-opening mask and/or an Metal-0 translation layer.

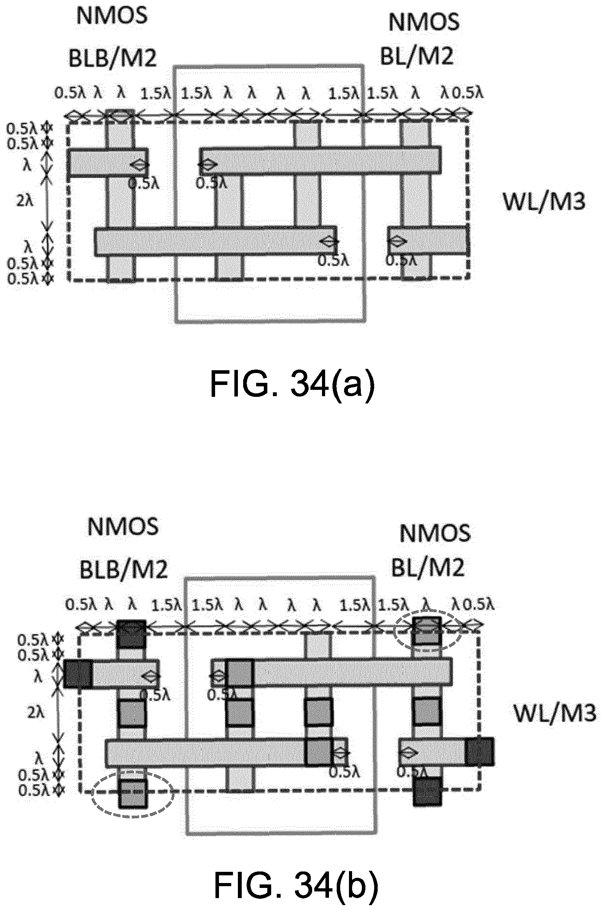

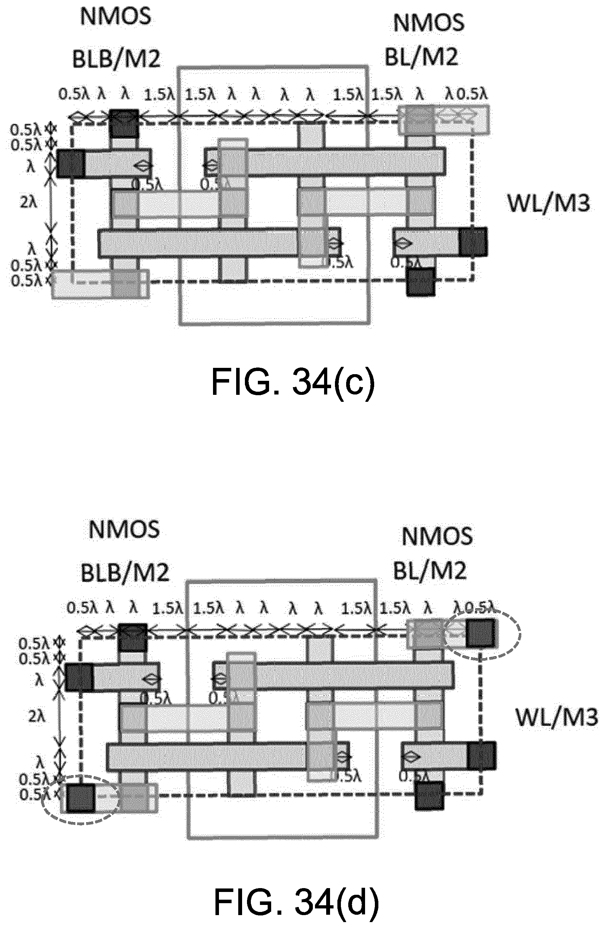

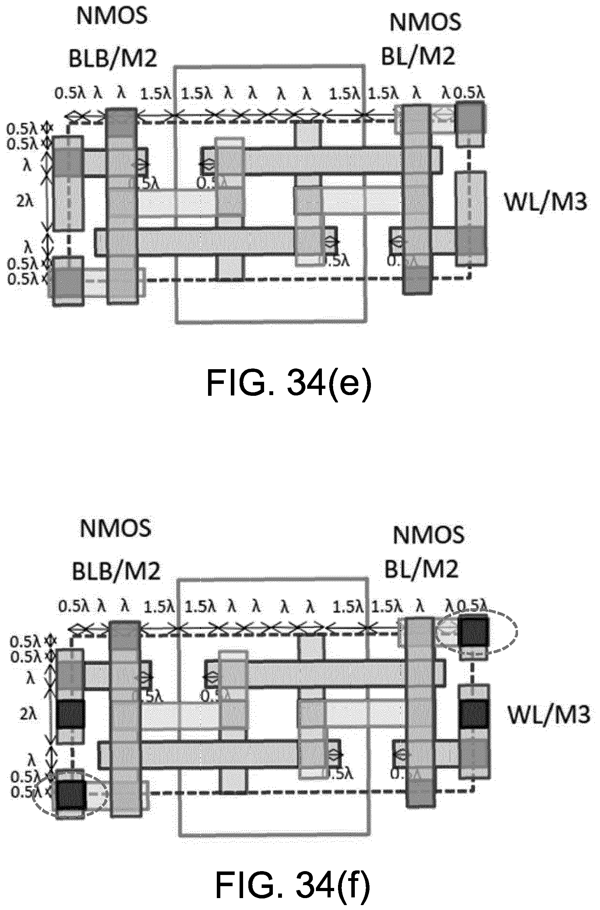

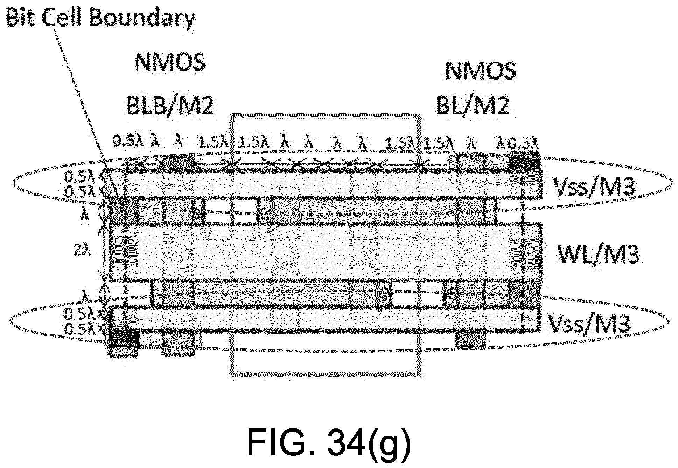

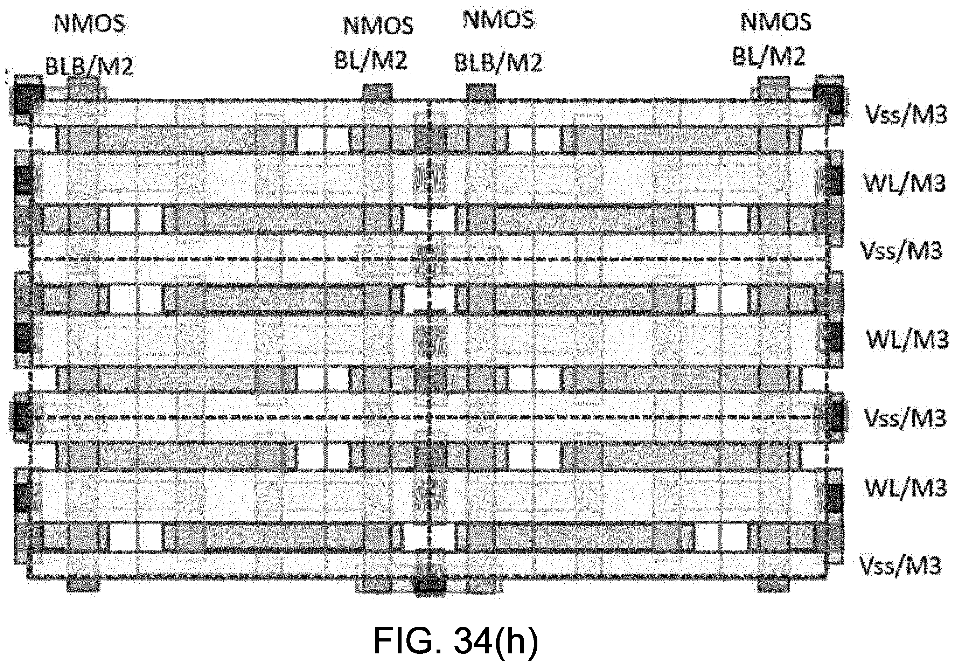

Figs. 34(a)~(h) shows another embodiment according to the present invention. As shown in Fig. 34(a) which is a copy of Fig. 31(b), the area of the SRAM cell in this embodiment is still 90λ². In Fig. 34(b), a plurality of CT_A (Opening VIA Mask layer for connecting AA (or Poly) to the Metal-1 layer) and CT_B (Opening VIA Mask layer for directly connecting AA (or Poly) to the Metal-2 layer) are formed. Comparing with Fig. 33(b), two more CT_A are formed (marked by dash ovals) in Fig. 34(b) for electrically coupling to the Vss later. In Fig. 34(c), the Metal-1 Mask layers (M1) are formed to connect the plurality of CT_A, however, the plurality of CT_B do not connect to the Metal-1 Mask layers (M1). In Fig. 34(d), a plurality of VIA1 (marked by dash ovals) for connecting the Metal-1 layer to the Metal-2 layer are formed. In Fig. 34(e), the Metal-2 Mask layers (M2) are formed at least to connect the plurality of CT_B and the plurality of VIA1. Some of the Metal-2 Mask layers (M2) are used as bit line (BL) and bit line bar (BLB). In Fig. 34(f), a plurality of VIA2 are formed, and part of VIA2 (marked by dash ovals) will be used to electrically coupling to the Vss. In Fig. 34(g) the Metal-3 Mask layers (M3) are formed to connect the plurality of VIA2. One Metal-3 Mask layer (M3) is used as the word line (WL), and the other two Metal-3 Mask layers (marked by dash ovals) are used as metal wires for connecting the Vss. Fig. 34(h) shows 6 SRAM cells of the present invention are arranged in a two dimensional array. In this embodiment, the metal wires for high level voltage VDD in the SRAM cell are distributed under the original silicon surface, but the metal wires for the low level voltage VSS are distributed above the silicon substrate. Additionally, as shown in Fig. 34(c), the Metal-1 Mask layers (M1) directly connects gate, source and/or drain regions through without using a conventional contact-hole-opening mask and/or an Metal-0 translation layer.

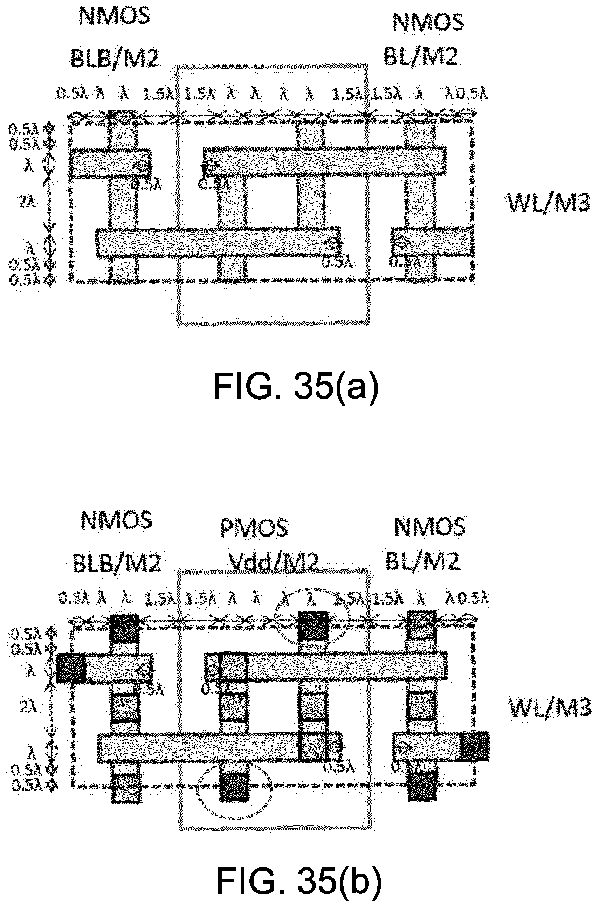

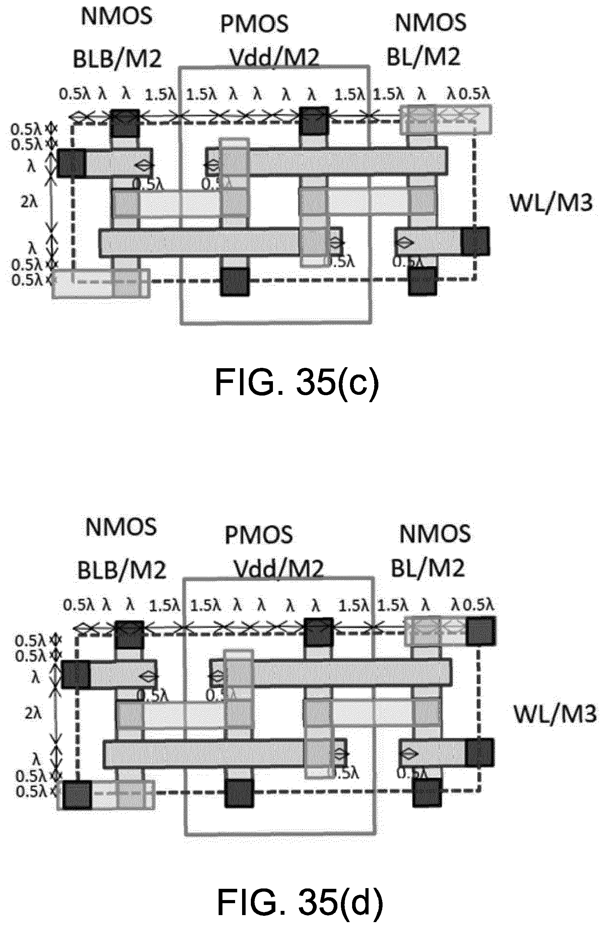

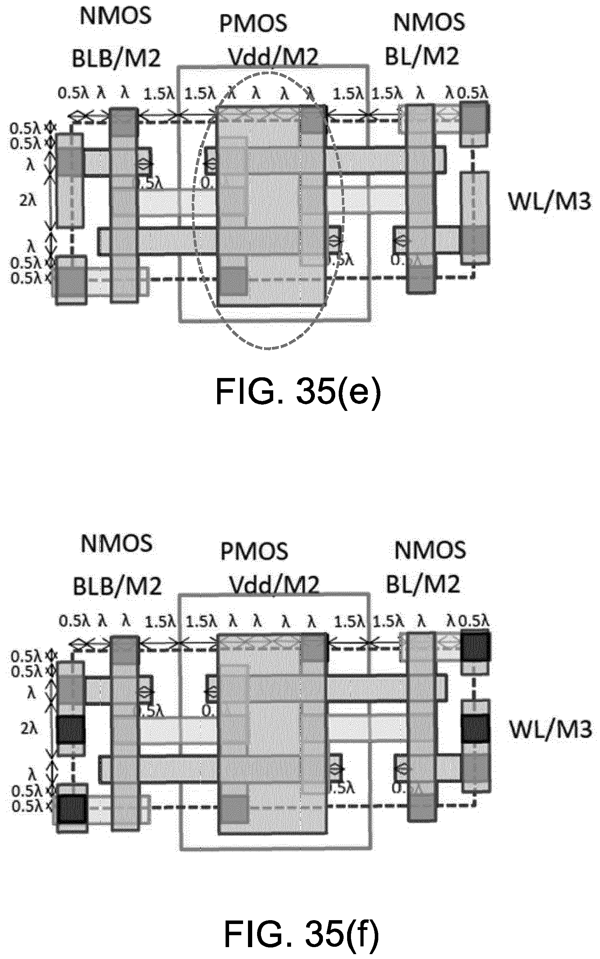

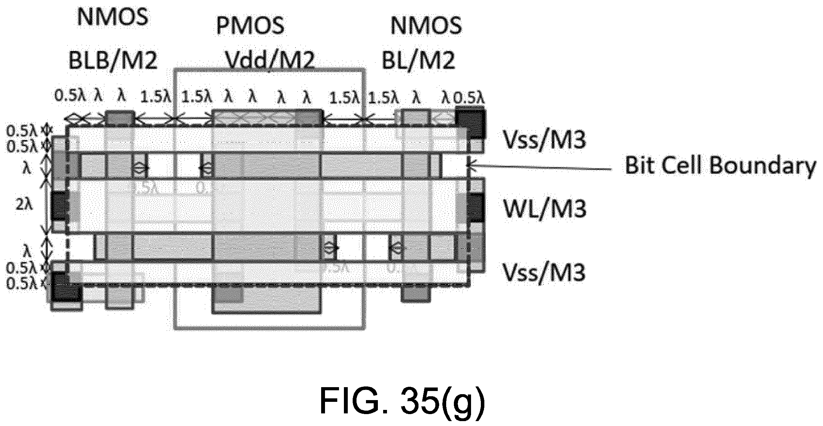

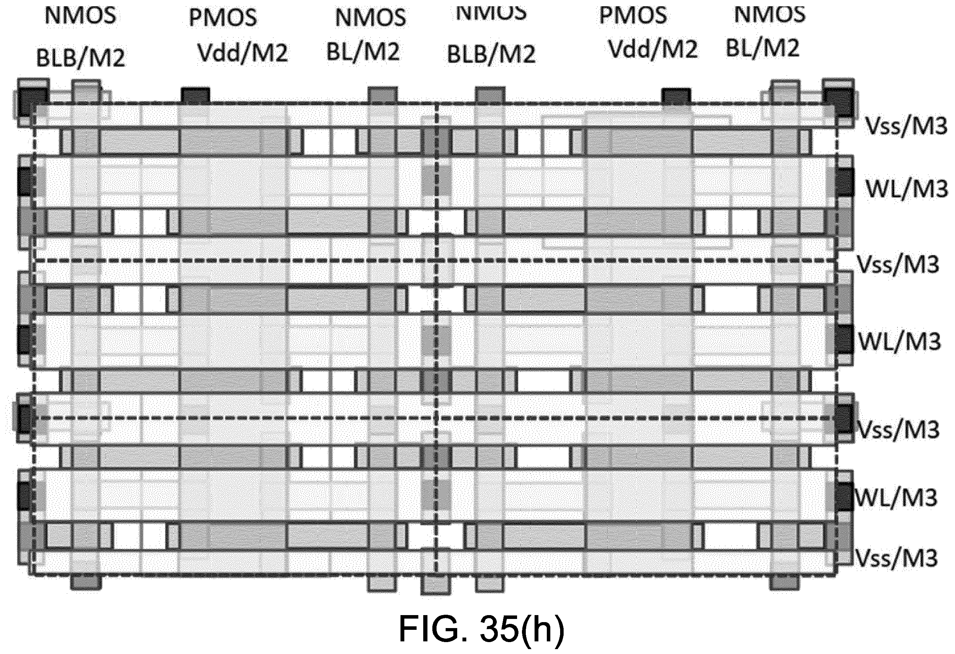

Figs. 35(a)~(h) shows another embodiment according to the present invention. As shown in Fig. 35(a) which is a copy of Fig. 31(b), the area of the SRAM cell in this embodiment is still 90λ². In Fig. 35(b), a plurality of CT_A (Opening VIA Mask layer for connecting AA (or Poly) to the Metal-1 layer) and CT_B (Opening VIA Mask layer for directly connecting AA (or Poly) to the Metal-2 layer) are formed. Comparing with Fig. 34(b), two more CT_B are formed (marked by dash ovals) in Fig. 35(b) for electrically coupling to the Vdd later. In Fig. 35(c), the Metal-1 Mask layers (M1) are formed to connect the plurality of CT_A, however, the plurality of CT_B do not connect to the Metal-1 Mask layers (M1). In Fig. 35(d), a plurality of VIA1 for connecting the Metal-1 layer to the Metal-2 layer are formed. In Fig. 35(e), the Metal-2 Mask layers (M2) are formed at least to connect the plurality of CT_B and the plurality of VIA1. Some of the Metal-2 Mask layers (M2) are used as bit line (BL) and bit line bar (BLB), and one Metal-2 Mask layers (M2) is used as the metal wire for the Vdd (marked by dash oval). In Fig. 35(f), a plurality of VIA2 are formed, and part of VIA2 will be used to electrically coupling to the Vss. In Fig. 35(g) the Metal-3 Mask layers (M3) are formed to connect the plurality of VIA2. One Metal-3 Mask layer (M3) is used as the word line (WL), and the other two Metal-3 Mask layers are used as metal wires for connecting the Vss. Fig. 35(h) shows 6 SRAM cells of the present invention are arranged in a two dimensional array. In this embodiment, the metal wires for high level voltage VDD and the low level voltage VSS are distributed above the silicon substrate. Additionally, as shown in Fig. 35(c), the Metal-1 Mask layers (M1) directly connects gate, source and/or drain regions through without using a conventional contact-hole-opening mask and/or an Metal-0 translation layer.

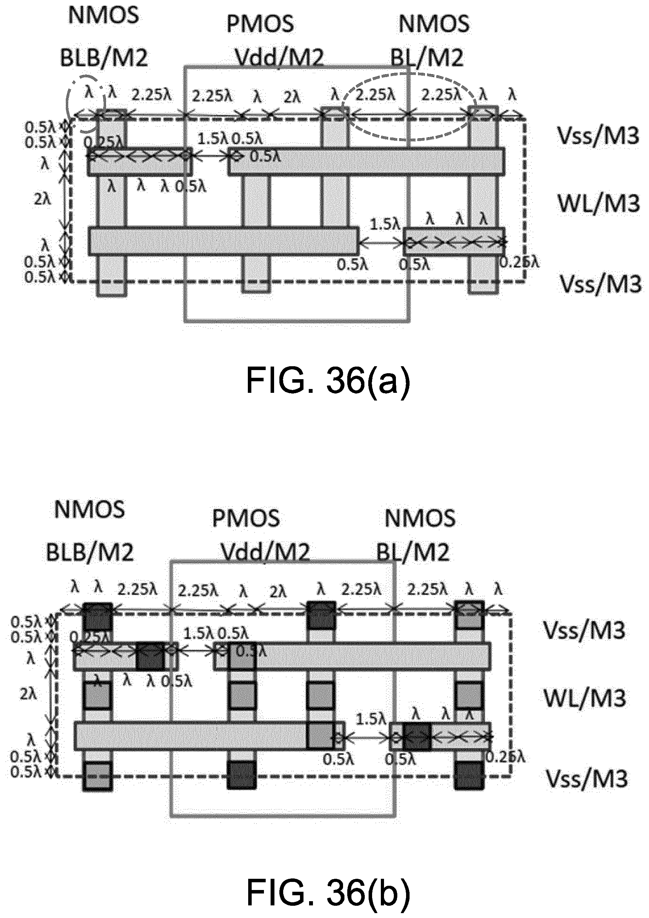

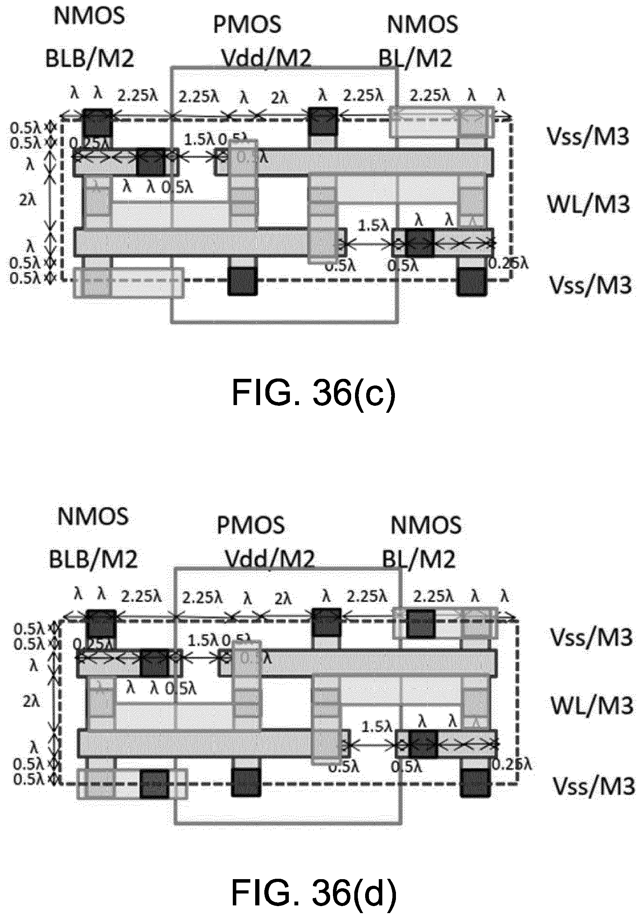

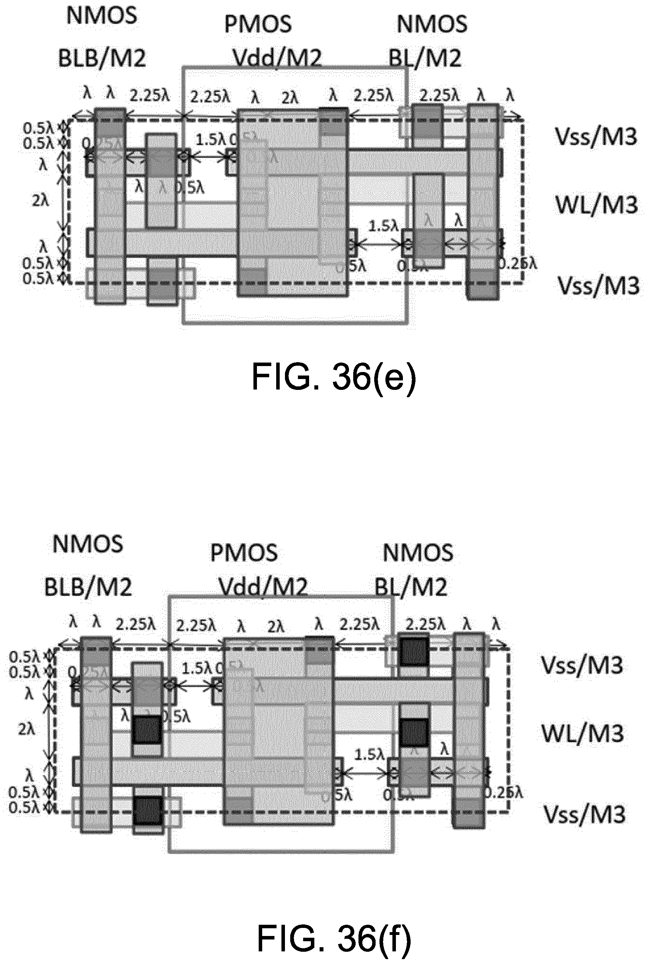

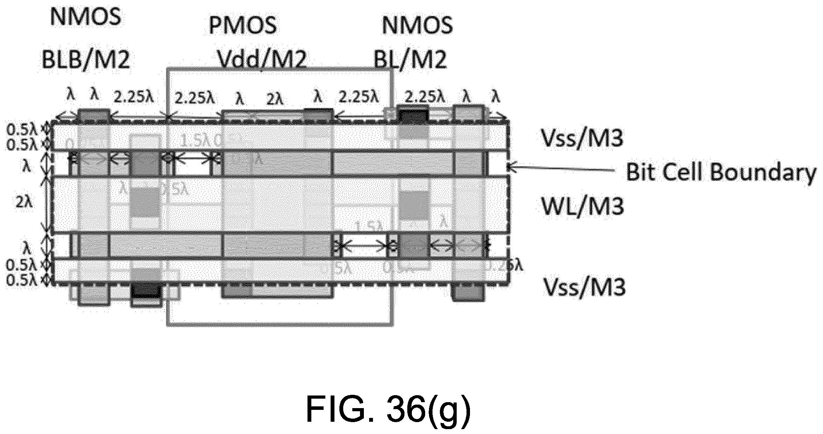

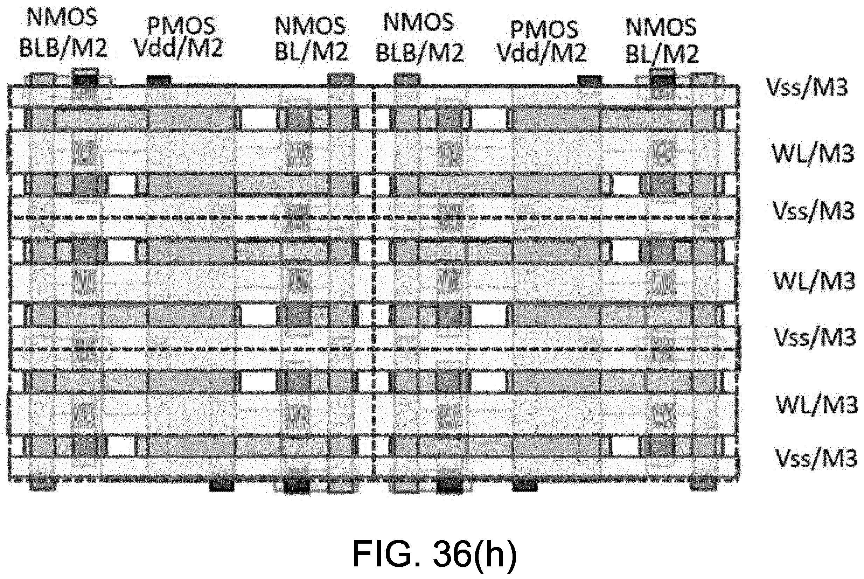

Figs. 36(a)~(h) shows another embodiment according to the present invention. As shown in Fig. 36(a), a little bit different from Fig. 31(b) or Fig. 35(a) is that, the isolation distance into silicon substrate to separate junctions in NMOS and PMOS transistors is set to 4.5λ (marked by dash oval) for high current application. Furthermore, the horizontal distance between the edge of the active region and the boundary of the SRAM cell or bit cell is aggressively set to 1λ (marked by dot-dash oval). Thus, for the stick diagram in Fig. 36(a), the horizontal length (x-direction) of the SRAM cell or bit cell is 17λ, and the vertical length (y-direction) of the SRAM cell or bit cell is still 6λ. Therefore, the area of the SRAM cell in this embodiment is still 102λ². The other process from Figs. 36(b)~ 36(h) are similar to those in Figs. 35(b)~ 35(h),therefore, the descriptions for Figs. 36(b)~ 36(h) are then skipped without repetition.

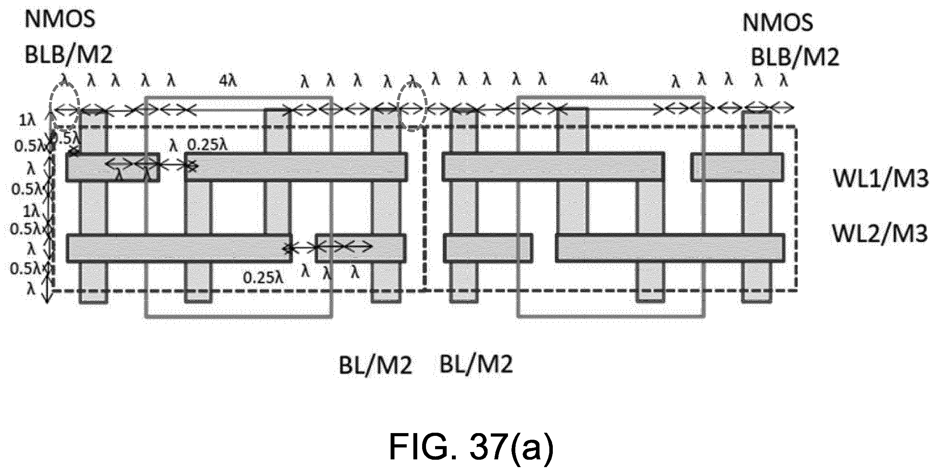

Figs. 37(a)~(h) shows another embodiment according to the present invention. In this embodiment, the adjacent SRAM bit cells in horizontal direction share the bit lines/bit line bars and interleaved word lines are used to control SRAM cells' operation. The stick diagrams of two adjacent SRAM bit cells are shown in Fig. 37(a). The horizontal distance between the edge of the active region and the boundary of the SRAM bit cell is aggressively set to 1λ (marked by dot-dash ovals), the other dimensions for the SRAM bit cell are the same as those in Fig. 33(b). Thus, the horizontal length (x-direction) of the SRAM cell or bit cell is 14λ, and the vertical length (y-direction) of the SRAM cell or bit cell is still 6λ. Therefore, the area of the SRAM cell in this embodiment is still 84λ².

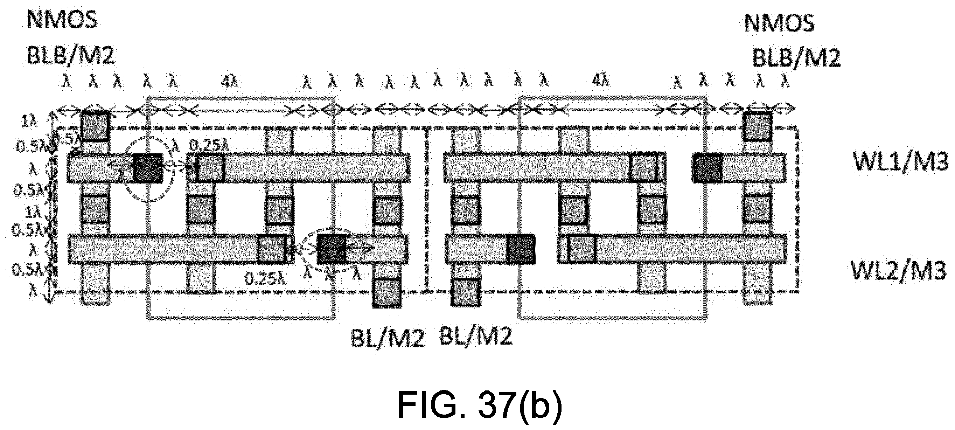

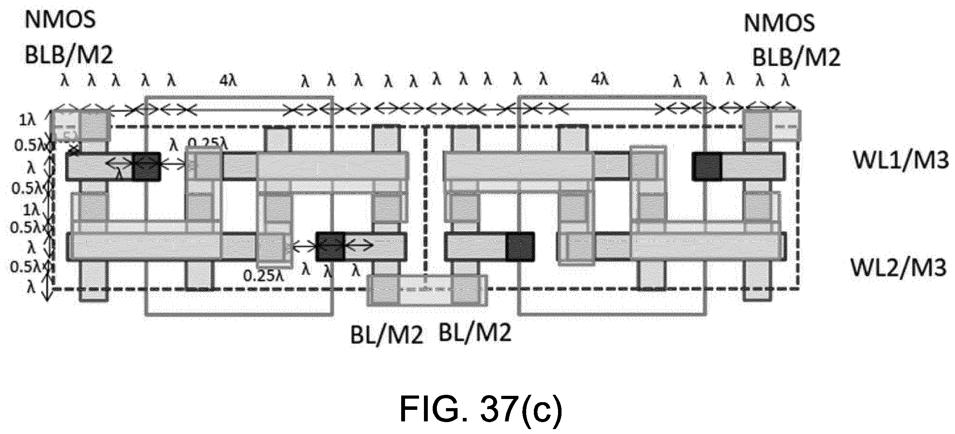

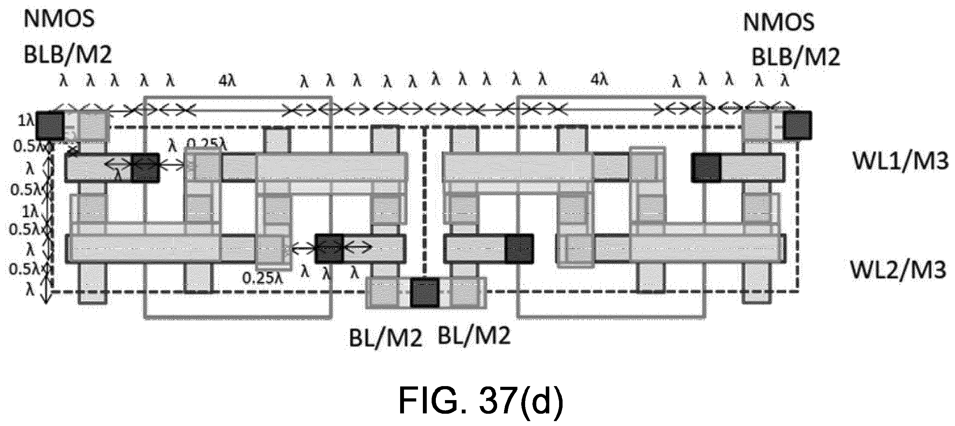

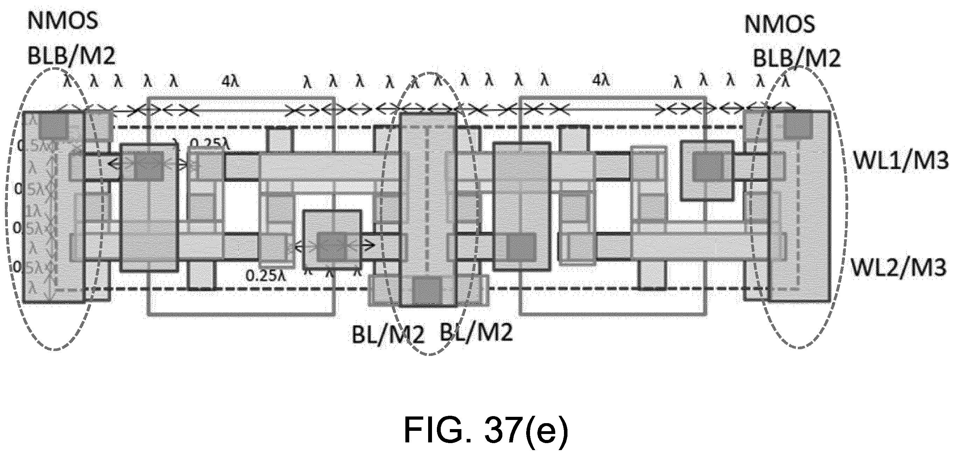

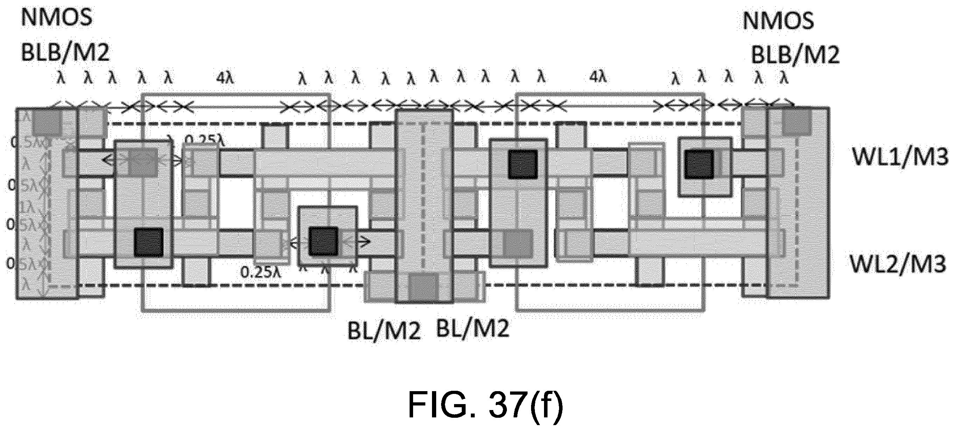

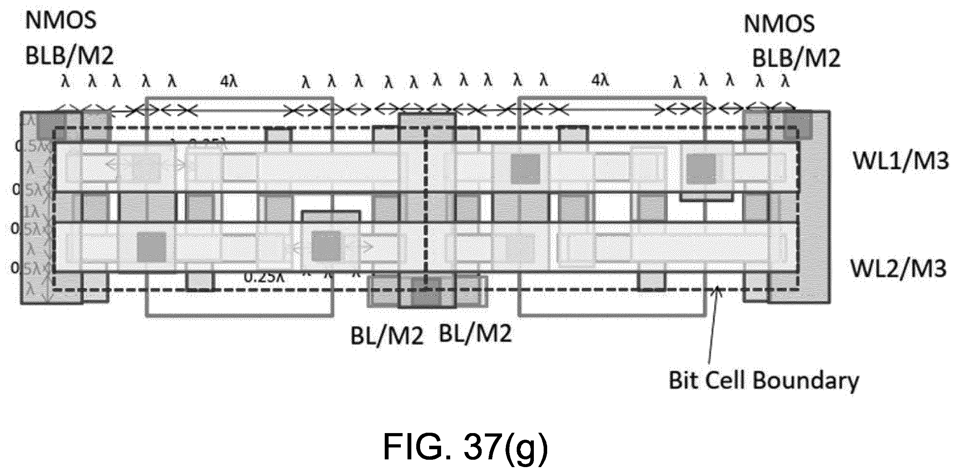

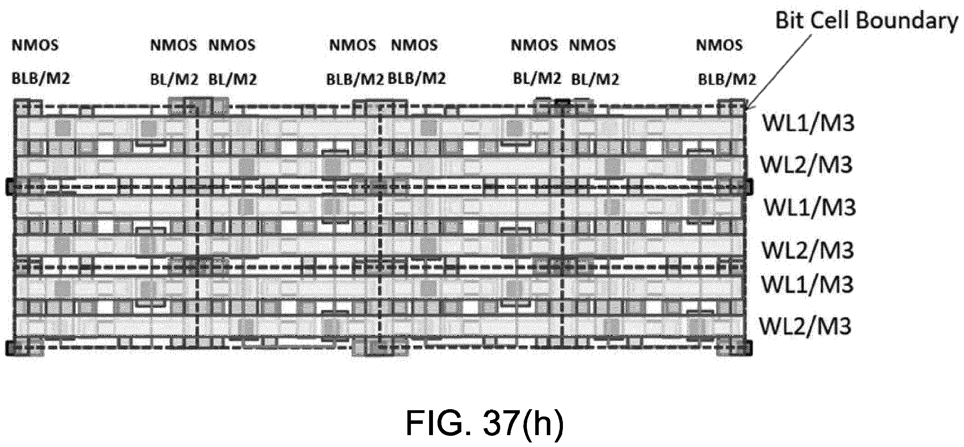

In Fig. 37(b), a plurality of CT_A (Opening VIA Mask layer for connecting AA (or Poly) to the Metal-1 layer) and CT_B (Opening VIA Mask layer for directly connecting AA (or Poly) to the Metal-2 layer) are formed. Comparing with Fig. 33(b), only two CT_B are formed (marked by dash ovals) in Fig. 37(b) for electrically coupling to the interleaved word lines (WL1 and WL2) later. In Fig. 37(c), the Metal-1 Mask layers (M1) are formed to connect the plurality of CT_A, however, the plurality of CT_B do not connect to the Metal-1 Mask layers (M1). In Fig. 37(d), a plurality of VIA1 for connecting the Metal-1 layer to the Metal-2 layer are formed. In Fig. 37(e), the Metal-2 Mask layers (M2) are formed at least to connect the plurality of CT_B and the plurality of VIA1. Some of the Metal-2 Mask layers (M2) are used as shared bit line (BL) and shared bit line bar (BLB), as marked by dash ovals. In Fig. 37(f), a plurality of VIA2 are formed, and part of VIA2 will be used to electrically coupling to the interleaved word lines (WL1/WL2). In Fig. 37(g) the Metal-3 Mask layers (M3) are formed to connect the plurality of VIA2. The Metal-3 Mask layers (M3) are used as the interleaved word lines (WL1/WL2). Fig. 37(h) shows 12 SRAM cells of the present invention are arranged in a two dimensional array. In this embodiment, the metal wires for high level voltage VDD and the low level voltage VSS are distributed under the silicon substrate. Additionally, as shown in Fig. 37(c), the Metal-1 Mask layers (M1) directly connects gate, source and/or drain regions through without using a conventional contact-hole-opening mask and/or an Metal-0 translation layer. Of course, the embodiment in Figs. 37(a)~(h) could be modified, such that the metal wires for high level voltage VDD and/or the low level voltage VSS are distributed above the silicon substrate.

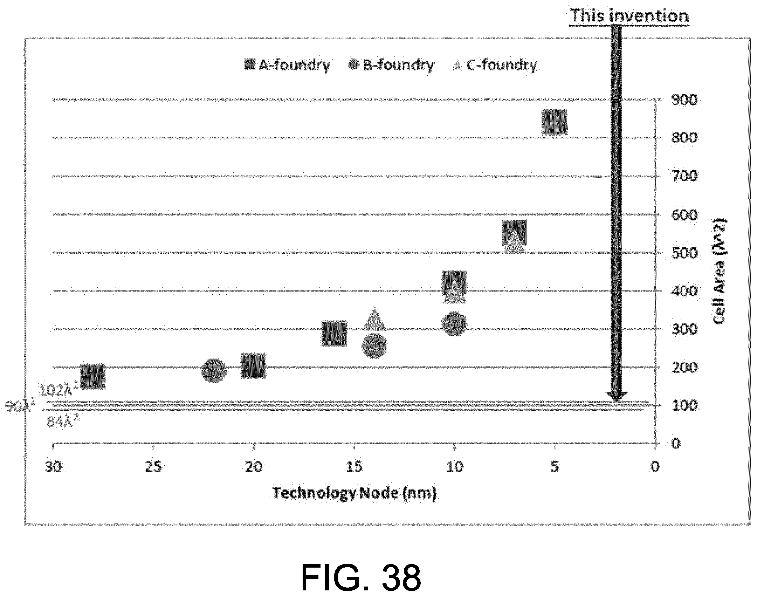

Figure 38 shows the SRAM cell area (in term λ²) across different technology nodes from three different foundries A, B, and C (data collected from published literatures). Moving toward smaller feature size technology, the larger SRAM cell size (in term λ²) can be observed. With the designs described in the present invention and their derivative designs, the SRAM cell area across different technology nodes can stay flat or less sensitive to the technology nodes, that is from technology node of 28nm to technology node of 5nm, the SRAM cell area according to the present invention can maintain within the range of 84λ²~102λ².

Of course, it is not necessary to utilize all improved technologies proposed in the new SRAM cell structure of the present invention, only one of the proposed technologies is enough to reduce the area of the SRAM cell structure, as compared with the transitional SRAM cell. For example, the shrinking area of active region (or just connecting gate/source/drain contact ("CT") to second metal layer) according to the present invention may cause the area of the SRAM within the range of 84λ²~700λ² at technology node of 5nm, within the range of 84λ²~450λ²at technology node of 7nm, within the range of 84λ²~280λ² at technology node from 10nm to more than 7nm, within the range of 84λ²~200λ² at technology node from 20nm to more than 10nm, and within the range of 84λ²~150λ² at technology node from 28nm to more than 20nm. For example, shrinking area of active region could cause the area of the SRAM within the range of 160λ²~240λ² (or more, if additional tolerance is required) at technology node of 5nm, and cause the area of the SRAM within the range of 107λ²~161λ² (or more, if additional tolerance is required) at technology node of 16nm.

Compared with the conventional area of SRAM (λ²) shown in Fig. 3, the linear dimension of the present invention could be 0.9 (or smaller, such as 0.85, 0.8, or 0.7) times the linear dimension of the conventional SRAMs of Fig. 3, and then the area of the present invention could be at least 0.81 (or smaller, such as 0.72, 0.64, or 0.5) times the area of the conventional SRAMs of Fig. 3, as shown in the following table.

| | | | | | | | | |
|---|---|---|---|---|---|---|---|---|
| λ(nm) | 28 | 22 | 20 | 16 | 14 | 10 | 7 | 5 |
| Fig. 3 (λ²) | 174 | 190 | 203 | 273 | 255 | 420 | 551 | 840 |
| The Present Invention (λ²) | 139.2 | 152 | 162.4 | 218.4 | 204 | 336 | 440.8 | 672 |
| shrunk to 0.81 | | | | | | | | |
| The Present Invention (λ²) shrunk to 0.72 | 125.28 | 136.8 | 146.16 | 196.56 | 183.6 | 302.4 | 396.72 | 604.8 |
| The Present Invention (λ²) shrunk to 0.64 | 111.36 | 121.6 | 129.92 | 174.72 | 163.2 | 268.8 | 352.64 | 537.6 |

Thus, in another embodiment of the present invention, an area of the SRAM cell of the present invention is not greater than 672λ² when a minimum feature size (λ) is 5nm. The area of the SRAM cell is not greater than 440λ² (or 400λ² or 350λ²) when the minimum feature size is 7nm. The area of the SRAM cell is not greater than 300λ² (or 268λ²) when the minimum feature size is between 10nm to more than 7nm. The area of the SRAM cell is not greater than 204λ² when the minimum feature size (λ) is between 16nm to more than 10nm. The area of the SRAM cell is not greater than 152λ² when the minimum feature size (λ) is between 22nm to more than 16nm. The area of the SRAM cell is not greater than 139λ² when the minimum feature size (λ) is between 28nm to more than 22nm.

Furthermore, in another embodiment, the area of the SRAM cell is within the range of 84λ²~672λ² when the minimum feature size is 5nm. The area of the SRAM cell is within the range of 84λ²~440λ² when the minimum feature size is 7nm. The area of the SRAM cell is within the range of 84λ²~300λ² when the minimum feature size is between 10nm to more than 7nm. The area of the SRAM cell is within the range of 84λ²~204λ² when the minimum feature size is between 16nm to more than 10nm. The area of the SRAM cell is within the range of 84λ²~152λ² when the minimum feature size is between 22nm to more than 16nm. The area of the SRAM cell is within the range of 84λ²~139λ² when the minimum feature size is between 28nm to more than 22nm.

Although the present invention has been illustrated and described with reference to the embodiments, it is to be understood that the invention is not to be limited to the disclosed embodiments, but on the contrary, is intended to cover various modifications and equivalent arrangements included within the spirit and scope of the appended claims.

## Claims

1. A SRAM cell, comprising:
a plurality of transistors;
a set of contacts coupled to the plurality of transistors;
a word-line electrically coupled to the plurality of transistors;
a bit-line and a bit line bar electrically coupled to the plurality of transistors;
a VDD contacting line electrically coupled to the plurality of transistors; and
a VSS contacting line electrically coupled to the plurality of transistors;
wherein as the minimum feature size of the SRAM cell gradually decreases from 28 nm, an area size of the SRAM cell in terms of square of a minimum feature size (λ) is the same or substantially the same.

2. The SRAM cell in claim 1, wherein when λ is decreased from 28 nm to 5 nm, the area size of the SRAM cell is between 84 λ² ~ 102 λ².

3. The SRAM cell in claim 1 or 2, wherein a length of one transistor is between 3 ~ 4 λ.

4. The SRAM cell in anyone of the claims 1 to 3, wherein a gate region of one transistor in the plurality of transistors is connected to a source region or a drain region of the transistor directly through a first metal interconnection without another metal layer lower than the first metal interconnection.

5. The SRAM cell in anyone of the claims 1 to 4, wherein the VDD contacting line or the VSS contacting line is distributed under an original silicon surface of a substrate from which the plurality of transistors are formed.

6. The SRAM cell in anyone of the claims 1 to 5, wherein a bottom surface of a n+ region of a NMOS transistor of the plurality of transistors is fully isolated by a first insulator, and a bottom surface of a p+ region of a PMOS transistor of the plurality of transistors is fully isolated by a second insulator.

7. The SRAM cell in claim 6, wherein an edge distance between the n+ region of the NMOS transistor and the p+ region of a PMOS transistor is between 2 λ ~ 4 λ.

8. The SRAM cell in anyone of the claims 1 to 7, wherein the set of contacts comprise a set of first contacts and a set of second contacts, the set of first contacts are connected to the first metal layer, and the set of second contacts are connected to the second metal layer but disconnected from the first metal layer.

9. A SRAM cell, comprising:
a plurality of transistors;
a set of contacts coupled to the plurality of transistors;
a word-line electrically coupled to the plurality of transistors;
a bit-line and a bit line bar electrically coupled to the plurality of transistors;
a VDD contacting line electrically coupled to the plurality of transistors; and
a VSS contacting line electrically coupled to the plurality of transistors;
wherein, an area of the SRAM cell is not greater than 67 2λ² when a minimum feature size (λ) is 5 nm; or the area of the SRAM cell is not greater than 440 λ² when the minimum feature size is 7 nm; or the area of the SRAM cell is not greater than 300 λ² when the minimum feature size is between 10 nm to more than 7 nm; or the area of the SRAM cell is not greater than 204 λ² when the minimum feature size (λ) is between 16 nm to more than 10 nm; or the area of the SRAM cell is not greater than 152 λ² when the minimum feature size (λ) is between 22 nm to more than 16 nm; or the area of the SRAM cell is not greater than 139 λ² when the minimum feature size (λ) is between 28 nm to more than 22 nm.

10. The SRAM cell in claim 9, wherein the area of the SRAM cell is within the range of 84 λ² ~ 672 λ² when the minimum feature size is 5 nm.

11. The SRAM cell in claim 10, wherein the area of the SRAM cell is within the range of 84λ² ~ 440 λ² when the minimum feature size is 7 nm.

12. The SRAM cell in claim 11, wherein when the minimum feature size is between 16 nm to more than 10 nm, the area of the SRAM cell is within the range of 84 λ² ~ 204 λ².

13. The SRAM cell in claim 12, wherein when λ is between 28 nm to more than 22 nm, the area of the SRAM cell is within the range of 84 λ² ~ 139 λ².

14. A SRAM cell, comprising:
a plurality of transistors;
a plurality of contacts coupled to the plurality of transistors;
a first metal layer disposed above and electrically coupled to the plurality of transistors;
a second metal layer disposed above the first metal layer and electrically coupled to the plurality of transistors; and
a third metal layer disposed above the second metal layer and electrically coupled to the plurality of transistors;
wherein the plurality of contacts comprise a set of first contacts and a set of second contacts, the set of first contacts are connected to the first metal layer, and the set of second contacts are connected to the second metal layer but disconnected from the first metal layer.

15. The SRAM cell in claim 14, wherein a vertical length of the first contact is shorter than that of the second contact.

16. The SRAM cell in claim 14 or 15, wherein a gate region of one transistor in the plurality of transistors is connected to a source region or a drain region of the transistor directly through a first metal interconnection without another metal layer lower than the first metal interconnection.

17. The SRAM cell in anyone of the claims 14 to 16, wherein a bottom surface of a n+ region of a NMOS transistor of the plurality of transistors is fully isolated by a first insulator, and a bottom surface of a p+ region of a PMOS transistor of the plurality of transistors is fully isolated by a second insulator, and wherein an edge distance between the n+ region of the NMOS transistor and the p+ region of a PMOS transistor is between 2 λ ~ 4 λ.

18. A SRAM cell, comprising:
a plurality of transistors, wherein one transistor comprises:
a gate structure with a length;
a channel region;
a first conductive region electrically coupled to the channel region; and
a first contact hole positioned above the first conductive region;
wherein a periphery of the first contact hole is independent from a photolithography process.

19. The SRAM cell in claim 18, wherein the first contact hole includes a periphery surrounded by a circumference of the first conductive region.

20. The SRAM cell in claim 18 or 19, wherein a gate region of one transistor in the plurality of transistors is connected to a source region or a drain region of the transistor directly through a first metal interconnection without another metal layer lower than the first metal interconnection.
